Europäisches Patentamt

European Patent Office

Office européen des brevets

(19)

(11) **EP 1 536 284 A1**

(12) **EUROPEAN PATENT APPLICATION**
published in accordance with Art. 158(3) EPC

(43) Date of publication:
**01.06.2005 Bulletin 2005/22**

(51) Int Cl.7: **G03F 1/16**, H01L 21/027

(21) Application number: **03738621.6**

(86) International application number:
**PCT/JP2003/008377**

(22) Date of filing: **01.07.2003**

(87) International publication number:
**WO 2004/006017 (15.01.2004 Gazette 2004/03)**

(84) Designated Contracting States:
**AT BE BG CH CY CZ DE DK EE ES FI FR GB GR HU IE IT LI LU MC NL PT RO SE SI SK TR**

(30) Priority: **02.07.2002 JP 2002193168**
**10.07.2002 JP 2002200777**

(71) Applicant: **Sony Corporation**
**Tokyo 141-0001 (JP)**

(72) Inventor: **SUGAWARA, Minoru,**
**c/o SONY CORPORATION**
**Tokyo 141-0001 (JP)**

(74) Representative: **Thévenet, Jean-Bruno et al**
**Cabinet Beau de Loménie**
**158, rue de l'Université**
**75340 Paris Cédex 07 (FR)**

(54) **PHASE SHIFT MASK AND PRODUCTION METHOD THEREFOR AND PRODUCTION METHOD FOR SEMICONDUCTOR DEVICE**

(57) There is disclosed an extreme ultraviolet phase shift mask that may be constituted practically by obtaining an appropriate combination of a refractive index with an absorption coefficient, even in the case of a reflection of an extreme ultraviolet radiation. When constituting a phase shift mask (10) having a reflective mask blank with multilayered films (11) that reflects a short ultraviolet light and a first and a second regions (12a) and (12b) formed on the reflective mask blank with multilayered films (11), firstly, with reference to an arbitrary complex refractive index to the extreme ultraviolet radiation and an arbitrary thickness of a film, a phase and a reflectance of a reflected light contained in the extreme ultraviolet radiation based on the above complex refractive index and the above film thickness are specified. Then, each film thickness and each complex refractive index in formative films of the first and the second regions (12a) and (12b) are set based on the specific results of the phase and the reflectance to ensure that the reflected light contained in the exposure light in the first region (12a) and the reflected light contained in the exposure light in the second region (12b) create a prescribed phase difference.

FIG. 1A

FIG. 1B

**Description**

TECHNICAL FIELD

The present invention relates to a phase shift mask for use in a lithography process for forming a circuit pattern of a semiconductor apparatus, a fabrication method thereof, and a fabrication method of a semiconductor apparatus including the lithography process, and more particularly, to a phase shift mask adaptable to so-called extreme ultraviolet radiation, a fabrication method thereof, and a fabrication method of a semiconductor apparatus.

BACKGROUND ART

In recent years, with a micro-miniaturization of a semiconductor apparatus, a minimization of a pattern width (a line width) and an inter-pattern pitch, etc. have been required for a circuit pattern formed on a wafer and a resist pattern, etc. for forming the circuit pattern. Such requirement for the above minimization is satisfied by further shortening a wavelength of an ultraviolet light for use in an exposure of a resist. As the micro-miniaturization of the semiconductor apparatus has advanced, the ultraviolet light for use in the exposure has also required a shorter wavelength such as to apply a wavelength of 365 nm to a semiconductor apparatus of 350 nm in design rule, a wavelength of 248 nm to semiconductor apparatuses of 250 nm, and 180 nm in design rule and a wavelength of 193 nm to semiconductor apparatuses of 130 nm and 100 nm in design rule, for instance, leading to a use of an ultraviolet light having a further shorter wavelength down to 157 nm.

It is generally known that a resolution based on these wavelengths is expressed with a Rayleigh's formula in terms of $w = k1 \times (\lambda/NA)$, where w is a resolved pattern of a minimum width, NA is a numerical aperture of an optical projection lens, and $\lambda$ is a wavelength of an exposure light. Further, k1 is a process coefficient determined mainly depending on a resist performance and a selected resolution enhanced technology, etc., and it is known that the use of an optimum resist and an optimum resolution enhanced technology enables a selection of k1 to an extent of about 0.35. Incidentally, the resolution enhanced technology is intended to obtain a pattern smaller than a wavelength using selectively $\pm$ first order diffracted light contained in a light having been diffracted with a shielding pattern on a mask after a transmission through the mask.

According to the Rayleigh's formula, it may be appreciated that a minimum pattern width w adaptable to the use of the wavelength of 157 nm, for instance, reaches 61 nm, provided that a lens having NA of 0.9 is applied. That is, it is necessary to use an ultraviolet light having a wavelength shorter than 157 nm to obtain a pattern width smaller than 61 nm.

For the above reason, an examination has been made recently on the use of an ultraviolet light called an extreme ultraviolet (EUV: Extreme Ultra Violet) radiation having a wavelength of 13.5 nm as the ultraviolet light having the shorter wavelength than 157 nm. However, a light-transmitting material such as $CaF_2$ (Calcium Fluoride) and $SiO_2$ (Silicon Dioxide), for instance, is available for the ultraviolet light having the wavelength down to 157 nm, so that it is possible to fabricate a mask and an optical system that configured to transmit the above extreme ultraviolet radiation. On the contrary, as for the extreme ultraviolet radiation having the wavelength of 13.5 nm, there is no material that allows the above extreme ultraviolet radiation to be transmitted through a desired thickness. Thus, when the ultraviolet light having the wavelength of 13.5 nm is used, it is necessary to configure a mask and an optical system with a reflective mask and a reflecting optical system that allow a reflection of the light, instead of the light-transparent mask and the light-transmitting optical system.

The reflective mask when used requires that a light having been reflected from a mask surface should be led to an optical projection system without causing a mutual interference with a light incident on the mask. Thus, the light incident on the mask becomes inevitably necessary to be obliquely incident with an angle $\phi$ to a normal of the mask surface. This angle is determined from the numerical aperture NA of the optical projection lens, a mask magnification m and a size $\sigma$ of an illumination light source. Specifically, as for an exposure apparatus conditioned to be NA = 0.3 and $\sigma$ = 0.8, the use of a mask having a five-fold reduced magnification on the wafer, for instance, results in an incidence of the light on the mask with a solid angle of 3.44 $\pm$ 2.75°. Further, as for an exposure apparatus conditioned to be NA = 0.25 and $\sigma$ = 0.7, the use of a mask having a four-fold reduced magnification on the wafer results in the incidence of the light on the mask with the solid angle of 3.58 $\pm$ 2.51°. An incident angle of the exposure light incident on the mask is set so as to be normally close to 5° in consideration of these solid angles. The incident angle is defined herein as an angle that is formed with the normal to the mask surface.

When the extreme ultraviolet radiation having the wavelength of 13.5 nm is reflected with the above reflective mask, the exposure apparatus conditioned to be NA = 0.25, for instance, makes it possible to form a line width of 32.4 nm, provided that k1 $\geqq$ 0.6 is derived from the above mentioned Rayleigh's formula. That is, the use of the extreme ultraviolet radiation and the reflective mask that enables a pattern transfer with the extreme ultraviolet radiation is supposed to be adaptable also to the pattern width or pattern pitch minimization, etc. that has failed to be attained with the light-transparent mask and the light-transmitting optical system.

By the way, a demand for the micro-miniaturization has been rapidly increased in recent years, resulting in a need for a measure to meet a further minimization of the pattern width and the pattern pitch, etc. As for a gate line width requiring a small size in particular, for instance, there has been also the need for a line width of a size smaller than 32.4 nm, that is, a condition under which k1 < 0.6 is derived. Specifically, a gate line width of 15 nm resulting from a fabrication leads to the need for a 25 nm line width also as for a resist line width. In terms of the resist line width of 25 nm, k1 = 0.46 is derived from the Rayleigh's formula in the case of the exposure apparatus conditioned to be NA = 0.25 with the wavelength of 13.5 nm. In case of forming the line width of the above size, it is necessary to use not only the extreme ultraviolet radiation having the wavelength of 13.5 nm and the reflective mask that reflects this extreme ultraviolet radiation but also the resolution enhanced technology.

It is known that the resolution enhanced technology makes use of, in addition to (1) a modified illumination light source (an orbicular zonal illumination and a four-hole illumination etc.) and (2) a pupil filter (a orbicular zonal filter and a four-hole filter etc.) that selectively take advantage of ± primary diffracted light of a mask pattern, (3) a halftone phase shift mask, (4) a combination of the halftone phase shift mask with the modified illumination light source, or (5) a Levenson phase shift mask (which is also called "an alternating phase shift mask"). Each of(3), (4), and (5) (the halftone phase shift mask and the alternating phase shift mask are hereinafter referred generally to as "the phase shift mask") takes advantage of an optical phase difference, and is quite effective in enhancing a resolution performance and in increasing a pattern contrast, leading to a more frequent use for the lithography process than (1) or (2).

However, while the transparent mask that is of a light transmitting type is easy to constitute the phase shift mask as is generally known, the reflective mask adapted to the extreme ultraviolet radiation has a quite difficulty in configuring the phase shift mask. For instance, the transparent mask allows regions different in optical phase difference by 180° to be formed using a means of digging in a mask blank, in which case, however, an application of the above means to the reflective mask as it is causes also a change of an optical reflectance simultaneously with a digging-in of the mask blank, resulting in a failure to constitute the phase shift mask. Further, the transparent mask also allows the regions different in optical phase difference by 180° to be formed by taking advantage of a phase shift effect of a material, in which case, however, the application of the above phase shift effect to the reflective mask provides no constitution having a desired reflectance and the phase shift effect with a single material, because of an absence of a non-absorbent material for an exposure wavelength of the extreme ultraviolet radiation, resulting in the failure to constitute the phase shift mask. Furthermore, a reflective mask blank with multilayered films used for the reflective mask adapted to the extreme ultraviolet radiation is generally available in the form of a structure (composed of repeated layers as many as 40 layers, for instance) in which a Si (Silicon) layer and a Mo (Molybdenum) layer are alternately arranged in multiple layers, so that a technology has been proposed, in which regions whose orders of arrangements of the multiple layers are reversed to each other are formed individually to provide the regions having the phase difference of 180° and being equal in reflectance. However, it is quite difficult to fabricate a multilayered structure as described the above, resulting in no practical use of the phase shift mask of the above multilayered structure yet. For the above reasons, the reflecting phase shift mask adapted to the extreme ultraviolet radiation has been supposed that it is impossible to constitute this reflecting phase shift mask actually.

Thus, the present invention has been undertaken in view of a fact that a refractive index of a material suitably used as a masking material for the extreme ultraviolet wavelength is in a range of 0.89 to 1.01, and is thus intended to provide an extreme ultraviolet phase shift mask that may be configured actually by obtaining an appropriate combination of a refractive index with an absorption coefficient, a fabrication method thereof, and a fabrication method of a semiconductor apparatus.

DISCLOSURE OF THE INVENTION

According to the present invention, there is provided an exposure light phase shift mask devised to attain the above object, that is, an exposure light phase shift mask used to transfer a desired pattern to a light exposed material by a reflection of an exposure light, the phase shift mask being characterized by having a reflective mask blank with multilayered films that reflects the exposure light, and a first and a second regions formed on the reflective mask blank with multilayered films, wherein each film thickness and each complex refractive index in a formative film of the first region and a formative film of the second region are set to ensure that a reflected light contained in the exposure light in the first region and a reflected light contained in the exposure light in the second region form a prescribed phase difference.

Further, according to the present invention, there is also provided a fabrication method of a phase shift mask for an exposure light devised to attain the above object, that is, a fabrication method of a phase shift mask for an exposure light having a reflective mask blank with multilayered films that reflects an exposure light, and a first and a second regions formed on the reflective mask blank with multilayered films, and is characterized by specifying, with reference to an arbitrary complex refractive index to the exposure light and an arbitrary film thickness of each film formed on the reflective mask blank with multilayered films, a phase and a reflectance of a reflected light contained in the exposure light based on the above complex refractive index and the above film thickness, and by selecting, based on the specified phase and the specified reflectance, each film thickness and each complex refractive index in a formative film of the first region and a formative film of the second region to ensure that the reflected light contained in the exposure light in the first region and the reflected light contained in the exposure light in the second region create a prescribed phase difference.

Furthermore, according to the present invention, there is also provided a fabrication method of a semiconductor apparatus devised to attain the above object, that is, a fabrication method of a semiconductor apparatus including a lithography process of transferring a desired pattern to a light exposed material using an exposure light phase shift mask, and is characterized by specifying, with reference to an arbitrary complex refractive index to the exposure light and an arbitrary film thickness of each film formed on a reflective mask blank with multilayered films, a phase and a reflectance of a reflected light contained in the exposure light based on the above complex refractive index and the above film thickness, by selecting, based on the specified phase and the specified reflectance, each film thickness and each complex refractive index in a formative film of the first region and a formative film of the second region to ensure that the reflected light contained in the exposure light in the first region and the reflected light contained in the exposure light in the second region create a prescribed phase difference, by forming the formative film of the first region and the formative film of the second region on the reflective mask blank with multilayered films based on the selected complex refractive index and the selected film thickness to constitute an exposure light phase shift mask having the first region and the second region on the reflective mask blank with multilayered films, and by transferring the desired pattern to the light exposed material using the resultant exposure light phase shift mask.

According to the phase shift mask for the exposure light having the above constitution, the fabrication method of the phase shift mask using the above procedure and the fabrication method of the semiconductor apparatus using the above procedure, the first and the second regions formed on the reflective mask blank with multilayered films require that the film thickness and the complex refractive index in each of the first and the second regions are set to ensure that the reflected light contained in the exposure light in the first and the second regions creates the prescribed phase difference. Specifically, the formative films of the first and the second regions are deposited to reach the set film thickness, and each composing material of the formative films of the first and the second regions is selected to reach the set complex refractive index. The set complex refractive index may be reached by providing each formative film in the form of a multilayered structure consisting of a plurality of materials. Each film thickness and each complex refractive index in the formative films of the first and the second regions are adjusted to reach the set values as described the above, resulting in a creation of the prescribed phase difference ($180°$, for instance) in the reflected light contained in the exposure light between the first region and the second region.

The present invention is characterized in that the exposure light is the extreme ultraviolet radiation, X-rays, radioactive rays, ultraviolet rays, or a visible light. Further, it is also characterized in that the phase shift mask is a halftone phase shift mask or a Levenson phase shift mask.

Furthermore, the present invention is also characterized in that each film thickness and each complex refractive index in the formative film of the first region and the formative film of the second region are set using an iso-phase contour line and an iso-reflectance contour line, and the iso-phase contour line is calculated by fixing an imaginary part of the complex refractive index.

BRIEF DESCRIPTION OF THE DRAWINGS

FIGS. 1A and 1B are schematic views showing one example of a schematic configuration of a phase shift mask according to the present invention.

FIG. 2 is a flowchart showing a fabrication procedure of the phase shift mask in a first embodiment of the present invention.

FIG. 3 illustrates one specific example of an iso-phase contour line.

FIG. 4 illustrates one specific example of an iso-reflectance contour line.

FIG. 5 illustrates a real part distribution of a composite complex refractive index to a Ru film thickness and a TaN film thickness to obtain a halftone phase shift mask.

FIG. 6 illustrates a relation between a total film thickness in the halftone phase shift mask and a real part (n) of the composite complex refractive index and a reflectance (k).

FIG. 7 illustrates a relation between the total film thickness in the halftone phase shift mask and the Ru film thickness and the TaN film thickness.

FIG. 8 illustrates an imaginary part distribution of the composite complex refractive index to the Ru film thickness and the TaN film thickness to obtain the halftone phase shift mask.

FIG. 9 illustrates one example of a matrix-shaped arrangement of a phase difference and a half tone reflectance to a film thickness of a Ru layer and a film thickness of a TaN layer.

FIG. 10 illustrates one example of the matrix-shaped arrangement of the phase difference to the film thickness of the Ru layer and the film thickness of a Cr layer.

FIG. 11 illustrates one example of the matrix-shaped arrangement of the half tone reflectance to the film thickness of the Ru layer and the film thickness of the Cr layer.

FIG. 12 illustrates a light intensity distribution as for a hole pattern having a mask hole opening of 30 nm (indicated with wafer coordinates) in the case where a NA of the halftone phase shift mask is NA = 0.25.

FIG. 13 is a schematic view showing a sectional structure of one configuration of the halftone phase shift mask.

FIG. 14 is a flowchart showing a fabrication procedure of the phase shift mask in a second embodiment of the present invention.

FIG. 15 illustrates one specific example of the iso-phase contour line.

FIG. 16 is a schematic view showing a sectional structure of one configuration (a structure 1) of a Levenson phase shift mask.

FIG. 17 illustrates one example of an optimization (with a Mo film thickness as a parameter) of a phase and a reflectance with considerations of a multiple interference in film in the Levenson phase shift mask of the structure 1.

FIG. 18 illustrates the light intensity distribution in the Levenson phase shift mask of the structure 1.

FIG. 19 illustrates the phase difference (indicated on the wafer) of the Levenson phase shift mask of the structure 1.

FIG. 20 illustrates one example of a deposition procedure (Part 1) of the Levenson phase shift mask of the structure 1.

FIG. 21 illustrates one example of the deposition procedure (Part 2) of the Levenson phase shift mask of the structure 1.

FIG. 22 illustrates one example of the deposition procedure (Part 3) of the Levenson phase shift mask of the structure 1.

FIG. 23 illustrates one example of the deposition procedure (Part 4) of the Levenson phase shift mask of the structure 1.

FIG. 24 is a schematic view showing a sectional structure of a different constitution (a structure 2) of the Levenson phase shift mask.

FIG. 25 illustrates one example of the optimization (with the Mo film thickness as the parameter) of the phase and the reflectance with considerations of the multiple interference in film in the Levenson phase shift mask of the structure 2.

FIG. 26 illustrates the light intensity distribution in the Levenson phase shift mask of the structure 2.

FIG. 27 illustrates the phase difference (indicated on the wafer) of the Levenson phase shift mask of the structure 2.

FIG. 28 is a schematic view showing a sectional structure of a further different constitution (a structure 3) of the Levenson phase shift mask.

FIG. 29 illustrates one example of the optimization (with the Mo film thickness as the parameter) of the phase and the reflectance with considerations of the multiple interference in film in the Levenson phase shift mask of the structure 3.

FIG. 30 illustrates the light intensity distribution in the Levenson phase shift mask of the structure 3.

FIG. 31 illustrates the phase difference (indicated on the wafer) of the Levenson phase shift mask of the structure 3.

FIG. 32 is a schematic view showing a sectional structure of one constitution (a structure 4) in which a first region and a second region of the Levenson phase shift mask are in a flat form.

FIG. 33 illustrates one example of the optimization (with the Mo film thickness as the parameter) of the phase and the reflectance with considerations of the multiple interference in film in the Levenson phase shift mask of the structure 4.

FIG. 34 illustrates the light intensity distribution in the Levenson phase shift mask of the structure 4.

FIG. 35 illustrates the phase difference (indicated on the wafer) in the Levenson phase shift mask of the structure 4.

FIG. 36 illustrates one example of the deposition procedure (Part 3) of the Levenson phase shift mask of the structure 4.

FIG. 37 illustrates one example of the deposition procedure (Part 4) of the Levenson phase shift mask of the structure 4.

FIG. 38 is a schematic view showing a sectional structure of a different flat constitution (a structure 5) of the Levenson phase shift mask.

FIG. 39 illustrates one example of the optimization (with the Mo film thickness as the parameter) of the phase and the reflectance with considerations of the multiple interference in film in the Levenson phase shift mask of the structure 5.

FIG. 40 illustrates the light intensity distribution in the Levenson phase shift mask of the structure 5.

FIG. 41 illustrates the phase difference (indicated on the wafer) of the Levenson phase shift mask of the structure 5.

FIG. 42 is a schematic view showing a sectional structure of a further different flat constitution (a structure 6) of the Levenson phase shift mask.

FIG. 43 illustrates one example of the optimization (with the Mo film thickness as the parameter) of the phase and the reflectance with considerations of the multiple interference in film in the Levenson phase shift mask of the structure 6.

FIG. 44 illustrates the light intensity distribution in the Levenson phase shift mask of the structure 6.

FIG. 45 illustrates the phase difference (indicated on the wafer) in the Levenson phase shift mask of the structure 6.

FIG. 46 illustrates the light intensity distribution (NA = 0.25) to a mask TaN width (indicated on the wafer) in the Levenson phase shift mask of the structure 5.

FIG. 47 illustrates the light intensity distribution (NA = 0.25) to the mask TaN width (indicated on the wafer) in a conventional binary mask.

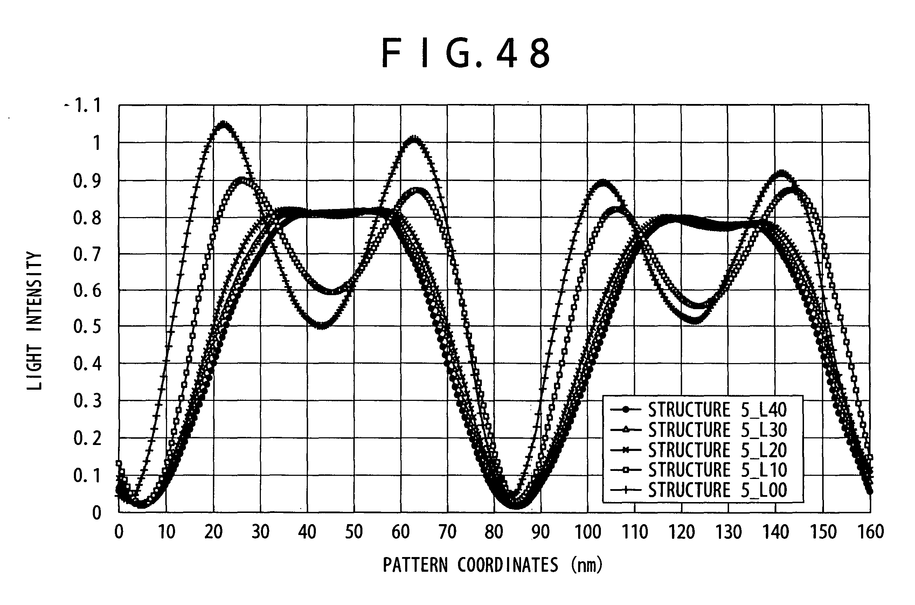

FIG. 48 illustrates the light intensity distribution (NA = 0.30) to the mask TaN width (indicated on the wafer) in the Levenson phase shift mask of the structure 5.

## BEST MODE FOR CARRYING OUT THE INVENTION

A phase shift mask for an exposure light, a method thereof, and a fabrication method of a semiconductor apparatus according to the present invention are hereinafter described with reference to the accompanying drawings by taking a case where an exposure light is specified as an extreme ultraviolet radiation. Incidentally, it is a matter of course that the present invention is not limited to embodiments described below.

(Description of schematic constitution of phase shift mask)

Firstly, a schematic constitution of a phase shift mask for an extreme ultraviolet radiation according to the present invention is described. The phase shift mask described herein is used to transfer a desired pattern (a circuit pattern, for instance) to a light exposed material such as a wafer by a reflection of the extreme ultraviolet radiation in a lithography process included in the fabrication method of semiconductor apparatus. Incidentally, an ultraviolet light having a shorter wavelength (in the range of 1 nm or above to 100 nm or below, for instance) than that of an ultraviolet light having been employed in a conventional lithography process, specifically, an ultraviolet light having a wavelength of 13.5 nm, for instance, is applicable to "the extreme ultraviolet radiation" specified herein.

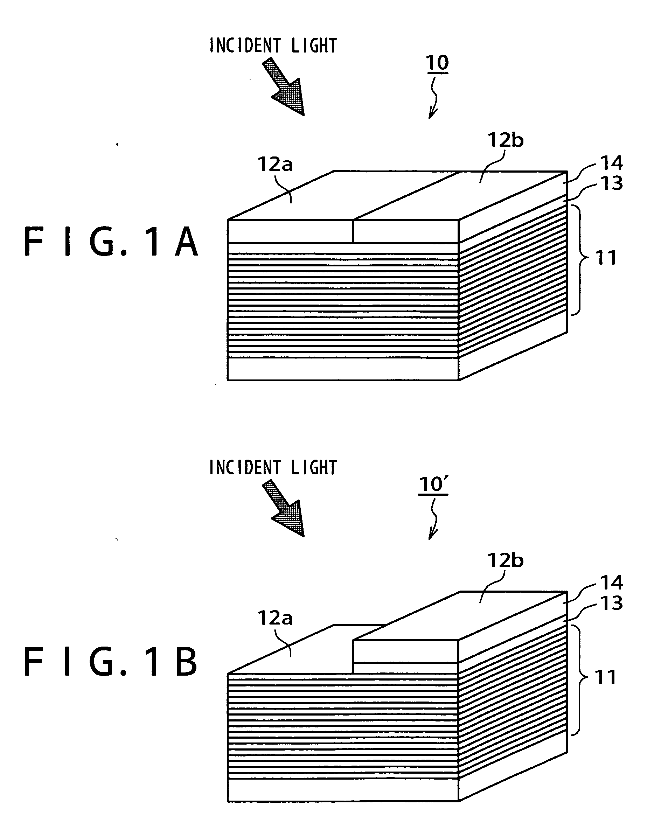

FIGS. 1A and 1B are schematic views showing one example of the schematic constitution of the phase shift mask according to the present invention. As shown in these figures, each of phase shift masks 10, 10' includes a reflective mask blank with multilayered films (mask blanks) 11 that reflects the extreme ultraviolet radiation, and a first and a second regions 12a and 12b that are formed on the reflective mask blank with multilayered films 11.

The reflective mask blank with multilayered films 11 is in the form of a structure in which a Si (Silicon) layer and a Mo (Molybdenum) layer are alternately arranged in multiple layers, in which case, a structure composed of repeated multiple layers as many as 40 layers is generally employed. Further, it is known that in terms of a ratio $\Gamma$ of a total thickness of the Si layer and the Mo layer to a thickness of the Mo layer, a Mo layer thickness/(Si layer thickness + Mo layer thickness) ratio = 0.4 is adequate. Thus, assuming that a wavelength $\lambda$ of the extreme ultraviolet radiation for use in an exposure is 13.5 nm, the reflective mask blank with multilayered films 11 requires that the total film thickness of the Si layer and the Mo layer reaches $(\lambda/2)/(0.9993 \times 0.6 + 0.9211 \times 0.4) = 6.973$ nm, where the Si layer is supposed to have a thickness of $6.9730 \times 0.6 = 4.184$ nm , and the Mo layer is supposed to have a thickness of $6.9730 \times 0.4 = 2.789$ nm.

The reflective mask blank with multilayered films 11 has thereon an absorption film 14 through a buffer film 13. The buffer film 13 is provided as an etching stopper being operative when forming the absorption film or for the purpose of avoiding damages at the time of a removal of defects after a formation of the absorption film, and is formed with a Ru (Ruthenium) layer or $SiO_2$ (Silicon Dioxide), for instance. The absorption film 14 consists of an extreme ultraviolet absorbing material, and is formed with a TaN (Tantalum Nitride) layer, for instance. However, the absorption film 14 may be one consisting of a different material as long as it is available as an extreme ultraviolet masking material. Specifically, Ta (Tantalum) or Ta compounds, Cr (Chromium) or Cr compounds and W (Tungsten) or W compounds, etc. are supposed to be available, in addition to the TaN.

By the way, the reflective mask blank with multilayered films 11 has thereon the first region 12a and the second region 12b. The first region 12a and the second region 12b are supposed to create a prescribed phase difference (180°,for instance) in the reflected light contained in the extreme ultraviolet radiation in each of the above regions. Thus, the first region 12a and the second region 12b differ in a composing material or a thickness of a formative film (the buffer film 13 + the absorption film 14) in each of the above regions (See FIG. 1A), as described later. However, it is also allowable to form the buffer film 13 and the absorption film 14 only on either of the above regions to ensure that the first region 12a and the second region 12b create the phase difference (See FIG. 1B).

Assuming that a phase difference between an incident light and a reflected light in the first region 12a is $\phi_1$, a phase difference between an incident light and a reflected light in the second region 12b is $\phi_2$, and a difference in the film thickness between the first region 12a and the second region 12b is h, a phase difference $\phi$ between the first region 12a and the second region 12b may be specified with the following expression (1)

$$\psi(\lambda) = \phi_1(\lambda) - \phi_2(\lambda) + (4\pi h \cos\theta)/\lambda \tag{1}$$

In the expression (1), the $\theta$ is an angle that the light incident on the mask forms with respect to a normal on a mask surface. A reference $\lambda$ is an exposure center wavelength. References $\phi_1$ and $\phi_2$ may be those obtained using a method disclosed by "Yamamoto and T. Namioka" "Layer-by-layer design method for soft-x-ray multilayers", Applied Optics, Vol. 31 pp 1622 to 1630, (1992),for instance.

Further, a complex refractive index of the composing material of each of the first region 12a and the second region 12b is required to calculate the phase difference $\varphi(\lambda)$ using the expression (1). In the case where the extreme ultraviolet radiation has the exposure center wavelength of 13.5 nm, the complex refractive index of each composing material results in Mo : 0.92108 - 0.00643543i, Si : 0.9993 - 0.00182645i, Ru : 0.88749 - 0.0174721i and TaN : 0.94136 - 0.0315738i, for instance. When the composing materials are in the form of a multilayered structure composed of arbitrary m layers, a composite complex refractive index

$$n = \sum_{}^{m} n_m d_m \bigg/ \sum_{}^{m} d_m \quad \cdots (2)^{;}$$

(2) and (3) may be used.

$$k = \sum_{1}^{m} k_m d_m \bigg/ \sum_{1}^{m} d_m \quad \cdots (3)$$

The phase shift masks 10, 10' require that the composing material (the complex refractive index, in particular) and the thickness of the formative film (the buffer film 13 + the absorption film 14) in each of the first and the second regions 12a and 12b are set to ensure that the first and the second regions 12a and 12b allow the phase difference $\varphi$ specified as described the above to reach the prescribed value (180°, for instance). That is, the phase shift masks 10, 10' described in the embodiment of the present invention have great features in that each film thickness and each complex refractive index in the formative film of the first region 12a and the formative film of the second region 12b are set to ensure that the reflected light contained in the extreme ultraviolet radiation in the first region 12a and the reflected light contained in the extreme ultraviolet radiation in the second region 12b create the prescribed phase difference.

(Description of fabrication procedure of phase shift mask)

A fabrication procedure of the phase shift masks 10, 10' having the above features is now described. However, a description in this section is given by classifying the above fabrication procedure into a first embodiment and a second embodiment.

(First embodiment)

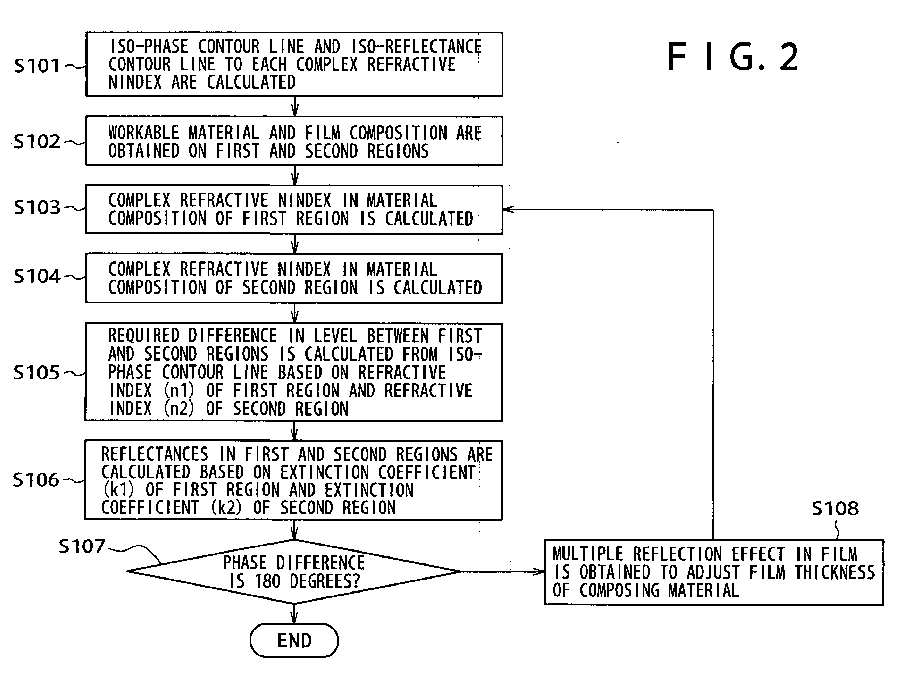

The first embodiment is described by taking the case where the present invention is applied to constitute a halftone phase shift mask. FIG. 2 is a flowchart showing the fabrication procedure of the phase shift mask in the first embodiment.

In a fabrication of the halftone phase shift mask, an iso-phase contour line and an iso-reflectance contour line to each complex refractive index are firstly calculated (Step 101, where Step is hereinafter abbreviated to "S"). A calculation of the iso-phase contour line and the iso-reflectance contour line is required for an arbitrary complex refractive index without being limited to the existing material. That is, with reference to the arbitrary complex refractive index to the extreme ultraviolet radiation, a phase and a reflectance of the reflected light contained in the extreme ultraviolet radiation based on the above arbitrary complex refractive index are specified. Incidentally, the phase and the reflectance to the complex refractive index may be specified theoretically uniquely. Further, it is also supposed that the arbitrary complex refractive index includes a complex refractive index of the reflective mask blank with multilayered films 11. That is, the calculation of the iso-phase contour line and the iso-reflectance contour line is also required for the reflective mask blank with multilayered films 11.

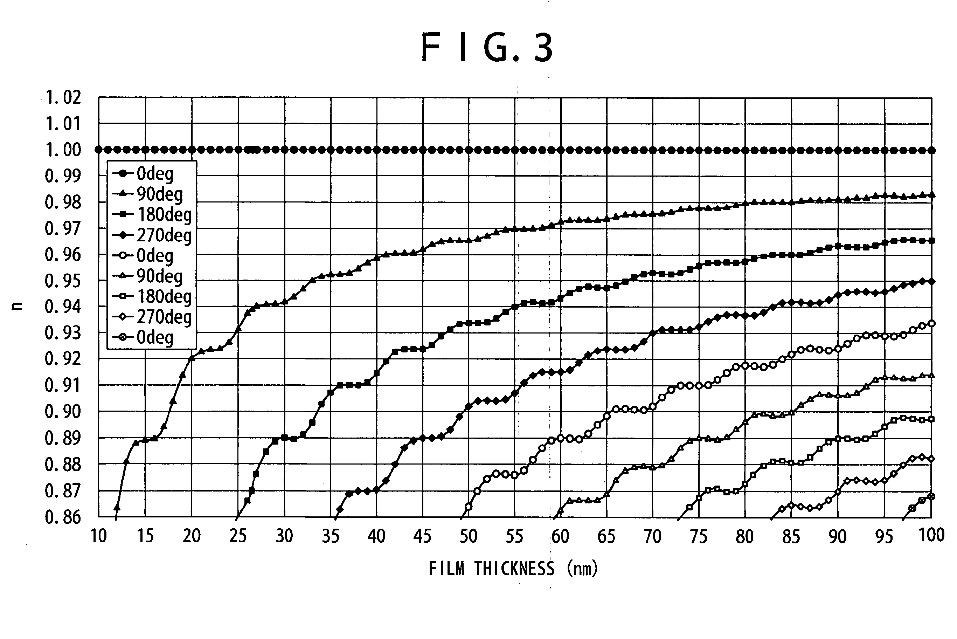

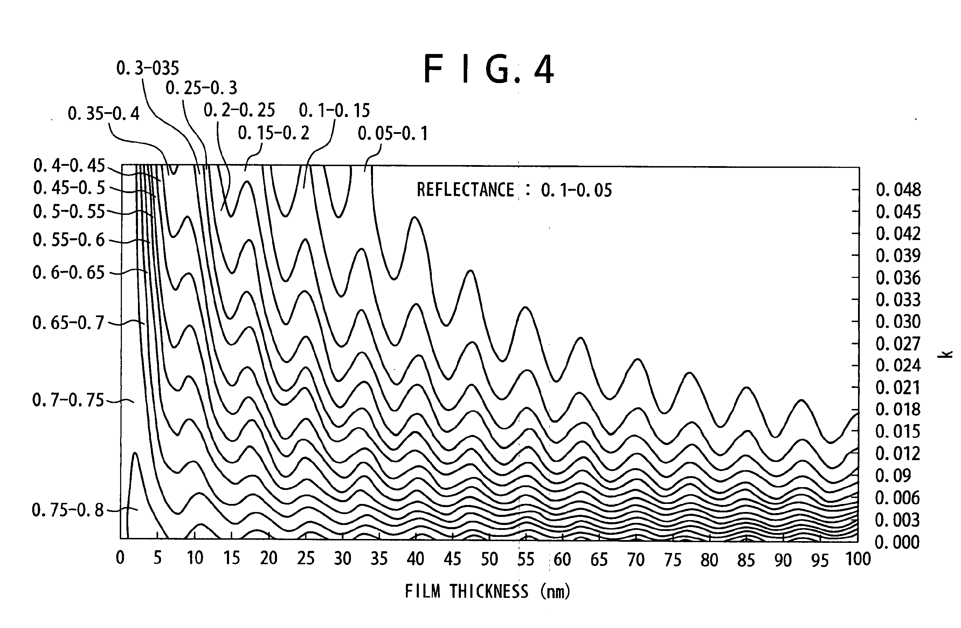

FIG. 3 illustrates one specific example of the iso-phase contour line. The illustrated iso-phase contour line is calculated by fixing an imaginary part (k) of the complex refractive index at 0.0100i. Further, FIG. 4 illustrates one specific example of the iso-reflectance contour line. The illustrated iso-reflectance contour line is calculated by fixing a real part (n) of the complex refractive index at 0.9100. Incidentally, in the illustrated iso-phase contour line and iso-reflectance contour line, an exposure wavelength denoted by $\lambda$ in the expression (1) is 13.5 nm, and an incident angle of the light obliquely incident on the mask as denoted by $\theta$ is 4.84°.

The reflectance and the phase respectively depend on the real part and the imaginary part of the complex refractive index, in which case, the phase is supposed to be mainly dependent on the real part of the complex refractive index, while the reflectance is supposed to be mainly dependent on the imaginary part of the complex refractive index. Thus, the first region 12a and the second region 12b may finally obtain the phase difference of 180° and the desired reflectance only by setting the complex refractive index or the film thickness of the composing material of each of the regions 12a and 12b using the iso-phase contour line in FIG. 3 and the iso-reflectance contour line in FIG. 4 in an approximate calculation manner. Alternatively, it is also allowable to set both the complex refractive index and the film thickness. In setting the complex refractive index or the film thickness, a material workable into the first and the second regions 12a and 12b on the reflective mask blank with multilayered films 11 and a film composition are firstly obtained (S102). Then, the complex refractive index in a material composition of the first region 12a and the complex refractive index in the material composition of the second region 12b are respectively calculated (S103, S104).

It is assumed that the case of a fabrication of the halftone phase shift mask 10' having the constitution shown in FIG. 1B, for instance, that is, a phase shift mask having the absorption film 14 only on the second region 12b through the buffer film 13 to ensure that the first region 12 and the second region 12b create the phase difference of 180°. In this case, each of the first region 12a and the second region 12b is supposed to obtain a desired reflectance (a mutually different value), respectively. Further, as for the second region 12b, Ru and TaN are supposed to be selected respectively as the composing material of the buffer film 13 and the composing material of the absorption film 14.

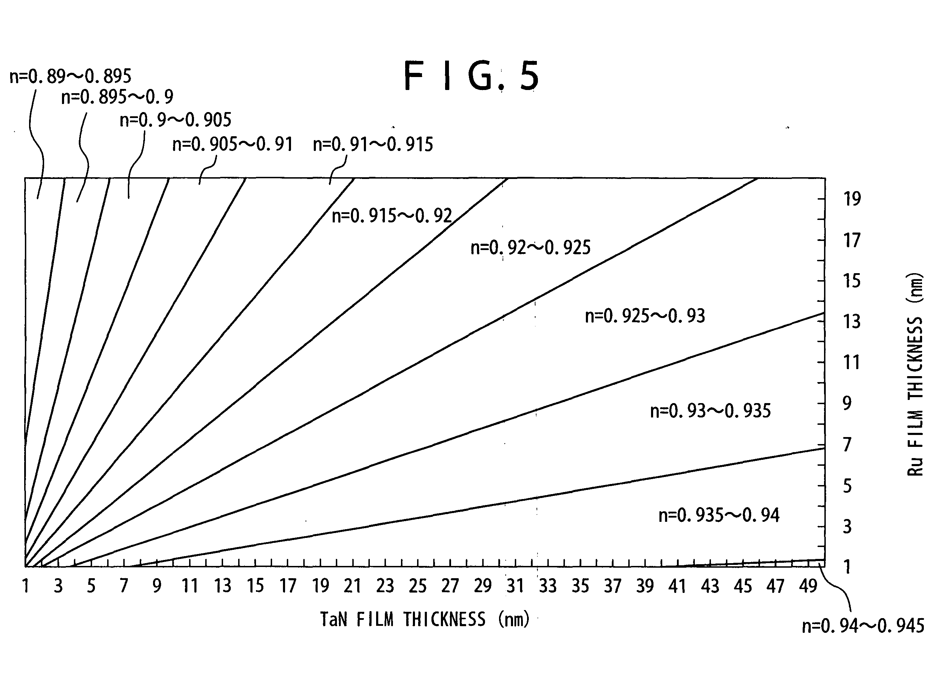

FIG. 5 illustrates a real part distribution of the complex refractive index to a Ru film thickness and a TaN film thickness. It may be appreciated from this illustration that the real part of the composite complex refractive index is capable of taking values ranging from 0.890 to 0.945 when the Ru film thickness varies from 1 nm to 20 nm and the TaN film thickness varies from 1 nm to 50 nm. That is, the complex refractive index in the material composition of the second region 12b may be found from the contents of FIG. 5. Incidentally, the first region 12a does not have either of the buffer film 13 and the absorption film 14, so that the complex refractive index may be calculated from the multilayered structure of the reflective mask blank with multilayered films 11.

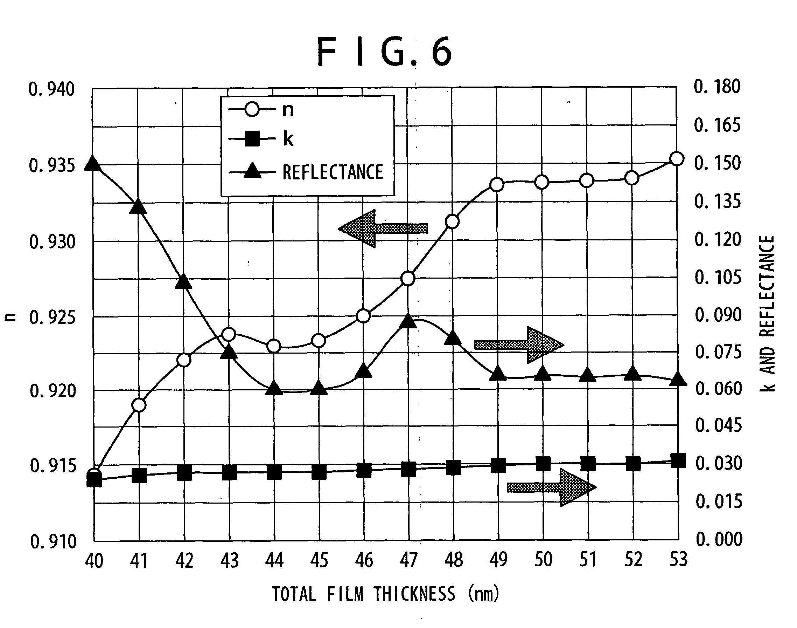

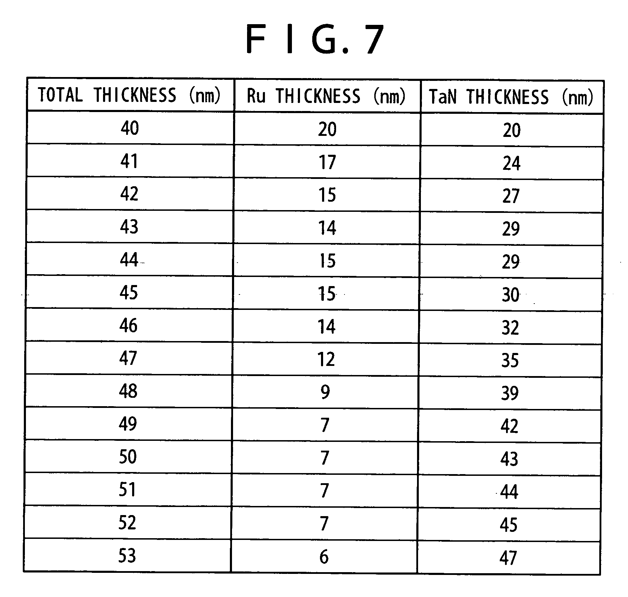

After the calculation of the respective complex indexes of refraction, a difference in a level of the formative film between the first region 12a and the second regions 12b, that is, the thickness of the formative film of the second region 12b is calculated from a refractive index in the first region 12a, a refractive index in the second region 12b and the already calculated iso-phase contour line (S105). Specifically, if the calculation is performed based on the distribution of the complex indexes of refraction in FIG. 5 and the iso-phase contour line diagram in FIG.3, a relation between the real part (n) of the composite complex refractive index and the total film thickness of the formative film (the buffer film 13 + the absorption film 14) required for the phase difference from the reflective mask blank with multilayered films 11 to reach 180° is calculated uniquely as shown in FIG. 6. Further, the film thickness of each of the Ru layer (the buffer film 13) and the TaN layer (the absorption film 14) required for the phase difference from the reflective mask blank with multilayered films 11 to reach 180° is calculated uniquely as shown in FIG. 7 based on a condition under which the composite complex refractive index provides the phase difference of 180°. The calculation of the thickness of the formative film of the second region 12b, that is, the film thickness of each of the Ru layer and the TaN layer will do in this manner.

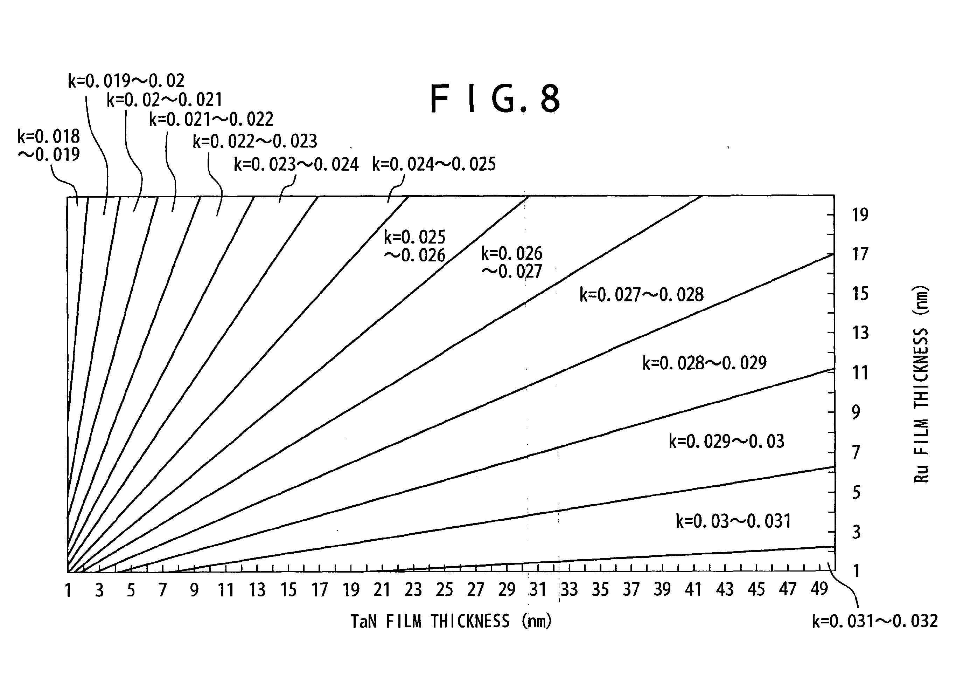

After the film thickness of each of the Ru layer and the TaN layer is obtained, the extreme ultraviolet reflectance in the formative film of the first region 12a and in the second region 12b is then calculated (S106). The reflectance may be obtained by calculating the imaginary part (k) of the composite complex refractive index to the total film thickness from the film thickness of each of the Ru layer and the TaN layer to calculate the reflectance from the calculated imaginary part of the composite complex refractive index. FIG. 8 illustrates a relation between the film thickness of each of the Ru layer and the TaN layer and the imaginary part (k) of the composite complex refractive index to the total film thickness. Further, if the imaginary part (k) of the complex refractive index is known, the reflectance is obtained uniquely from the iso-reflectance contour line shown in FIG. 4. In FIG. 6, there is also shown a relation between the imaginary part (k) of the composite complex refractive index and the reflectance and the total film thickness.

When the reflectance is set at 0.075, for instance, the total film thickness of 43 nm is derived from the contents of FIG. 6, in which case, 14 nm in the film thickness of the Ru layer and 29 nm in the film thickness of the TaN layer are obtained as the most adaptable conditions from the contents of FIG. 7. A halftone phase shift having a phase difference of 182.4° and a reflectance of 0.075 is supposed to be obtained by calculating, with reference to this film thickness, the phase difference and the reflectance further using an accurate value of the composite complex refractive index as described later.

However, according to the contents of FIG. 6, it may be seen that a film thickness condition required for the reflectance to be set at 0.075 is existent also in the vicinity of 46.3 nm and 48.3 nm in the total film thickness. That is, the total film thickness is not one determined as a single condition from the complex refractive index, and therefore, needs to be determined in consideration of various conditions synthetically inclusive of a film thickness adjustment described below. In this case, it is desirable to set at a flat change portion of the total film thickness in FIG. 6 (in the vicinity of 50.5 nm, for instance) to largely make sure of a process margin for the complex refractive index to film thickness variations in a mask fabrication. Thus, even if the total film thickness varies in the range of about $\pm$ 1.5 nm, the complex refractive index is unchanged, so that the phase difference and the reflectance also remain unchanged.

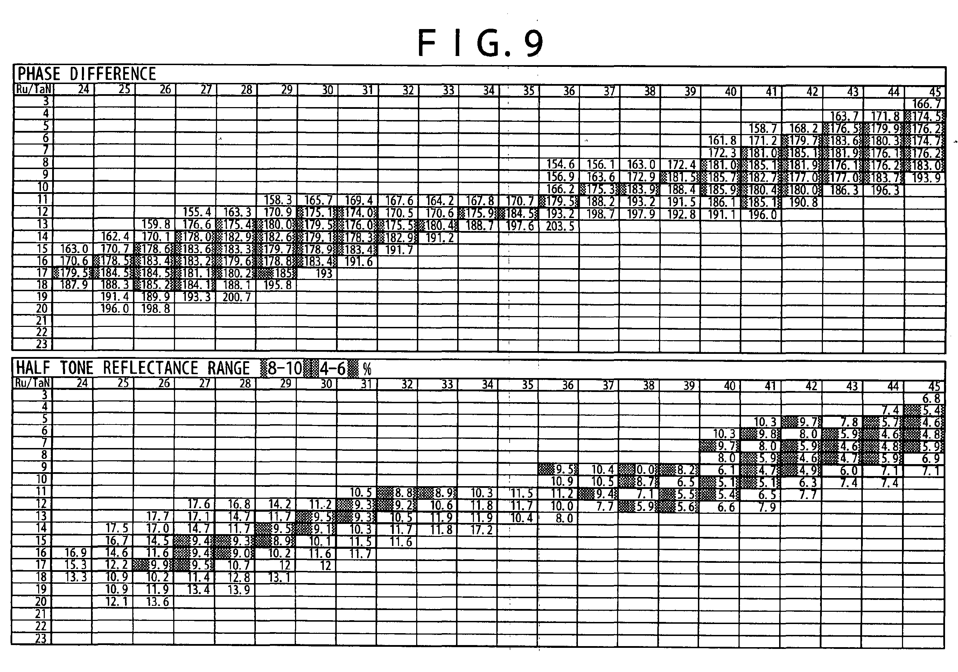

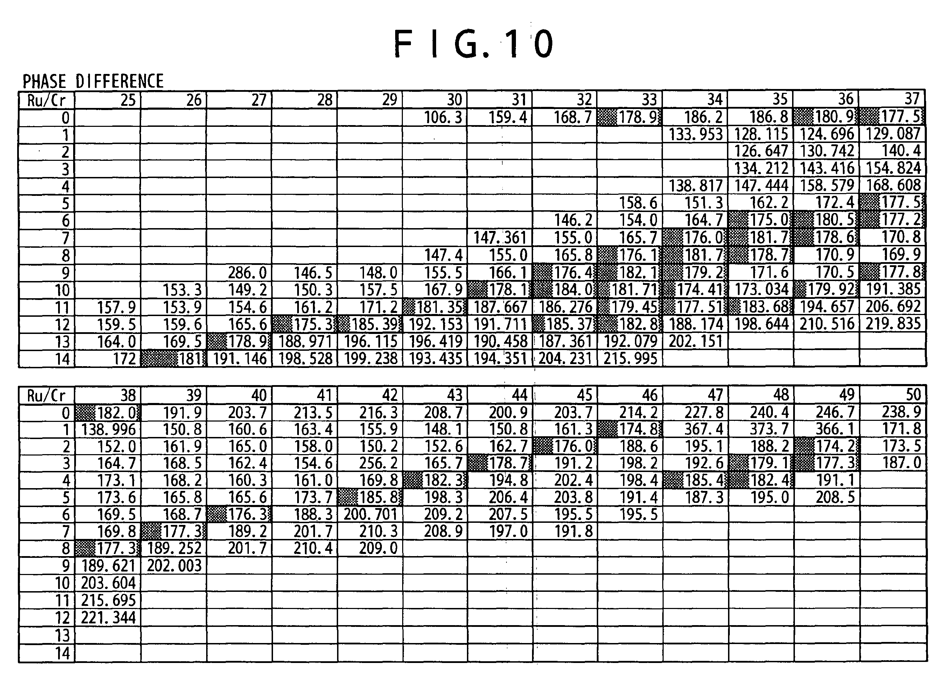

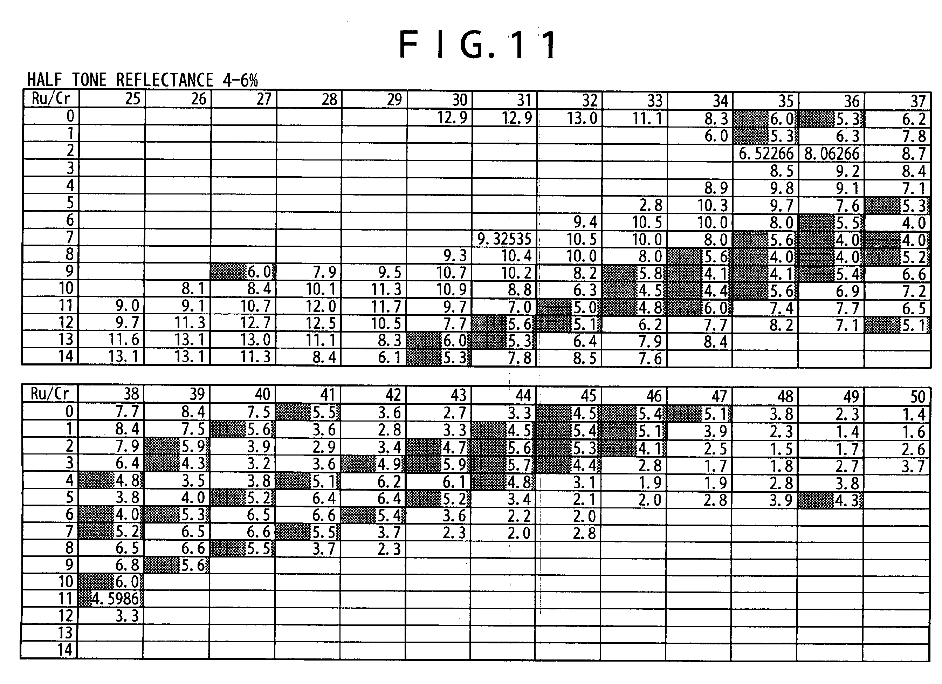

Thereafter, the film thickness adjustment is further performed so that the first region 12a and the second region 12b obtain the phase of 180° and the desired reflectance (S107, S108). A further given reason for the film thickness adjustment is to obtain the desired phase and the desired reflectance inclusive of a multiple interference effect in film that is not taken into consideration in FIG. 6. Specifically, each phase difference and each half tone reflectance applicable to the case of appropriate variations of the film thickness of the Ru layer and the film thickness of the TaN layer are calculated according to a procedure described the above. FIG. 9 illustrates one example of a matrix-shaped arrangement of the phase difference and the half tone reflectance to the film thickness of the Ru layer and the film thickness of the TaN layer. The half tone reflectance is herein specified as a difference between the reflectance of the first region 12a and the reflectance of the second region 12b in the phase shift mask 10' shown in FIG. 1B. Then, a window satisfying the desired phase difference and the desired half tone reflectance, that is, a set value of the film thickness obtained after the adjustment may be selected from these results. Incidentally, in FIG. 9, there is shown the case of the phase difference of 180.0 $\pm$ 6° and the half tone reflectance of 9.0 $\pm$ 1 %, and the case of the phase difference of 180.0 $\pm$ 6° and the half tone reflectance of 5.0 $\pm$ 1 % (See a shadow part in FIG. 9). Thus, the halftone phase shift having the phase difference of 179.4° and the half tone reflectance of 9.5 % is supposed to be obtained by setting the film thickness of the Ru layer at 13 nm and the film thickness of the TaN layer at 30 nm. Herein, the reflectance reaches 0.0070, which approximately agrees with an estimated value obtained in FIG. 6. FIGS. 10 and 11 illustrate different matrix-shaped arrangements of the phase difference and the half tone reflectance to the film thickness of the Ru layer and the film thickness of a Cr layer. Thus, the half tone phase shift mask having the phase difference of 179.2° and the halftone reflectance of 4.1 % is supposed to be obtained by setting the film thickness of the Ru layer at 9 nm and the film thickness of the Cr layer at 34 nm.

The setting of the complex refractive index and the thickness of the formative film of the second region 12b as described the above may be followed by a deposition of the above formative film on the reflective mask blank with multilayered films 11 according to the above setting to constitute the halftone phase shift mask. Incidentally, the deposition of the formative film may be performed using a well-known technology, and therefore, a description thereof is herein omitted.

That is, the phase difference from the reflective mask blank with multilayered films 11 in the second region 12b is calculated from the film thickness and the real part of the complex refractive index of a group of the materials composing the second region 12b formed on the reflective mask blank with multilayered films 11, and the reflectance in the second region 12b is calculated from the film thickness and the imaginary part of the complex refractive index of the group of the materials composing the second region 12b, thereby providing, based on the calculated phase difference and the calculated reflectance, the halftone phase shift mask of the above constitution, that is, one in which the first region 12a (the reflective mask blank with multilayered films 11) and the second region 12b are different in the phase difference by 180° and the reflectance of the second region 12b reaches a desired value. However, it does not matter if the calculation on which of the phase difference and the reflectance is performed earlier.

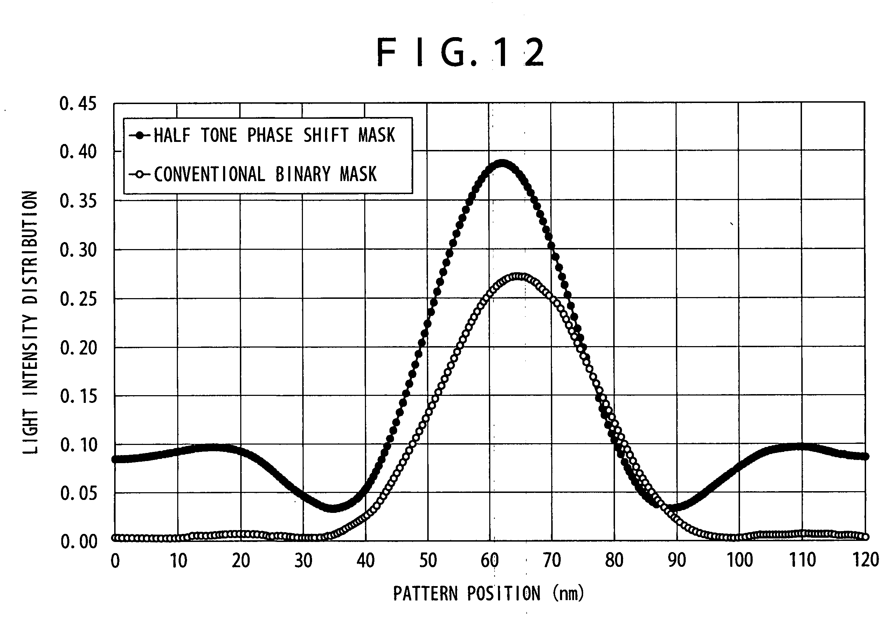

A light intensity distribution in the case of the use of the halftone phase shift mask obtained according to the above procedure is described. FIG. 12 illustrates the light intensity distribution as for a hole pattern having a mask hole opening of 30 nm (indicated with wafer coordinates, where a four-fold mask requires the hole opening of 120 nm), when optical conditions of NA = 0.25 and σ = 0.70 are applied. In FIG. 12, there is also shown the light intensity distribution as for a conventional binary mask, for a comparison. According to this illustration, it is apparent that the use of the halftone phase shift mask enables an effect of increasing a pattern edge contrast to be obtained, as compared with the conventional binary mask.

Incidentally, while the phase shift mask 10' of the constitution shown in FIG. 1B, that is, one having the buffer film 13 and the absorption film 14 only on the second region 12b is taken as the instance of the halftone phase shift mask, it is also allowable to constitute the halftone phase shift mask 10 as shown in FIG. 1A, for instance. However, even in the case of the halftone phase shift mask 10, the first region 12a and the second region 12b require that the film thickness and the complex refractive index of the formative film of each of the above regions are set to ensure that the phase difference of 180° is created, as described the above.

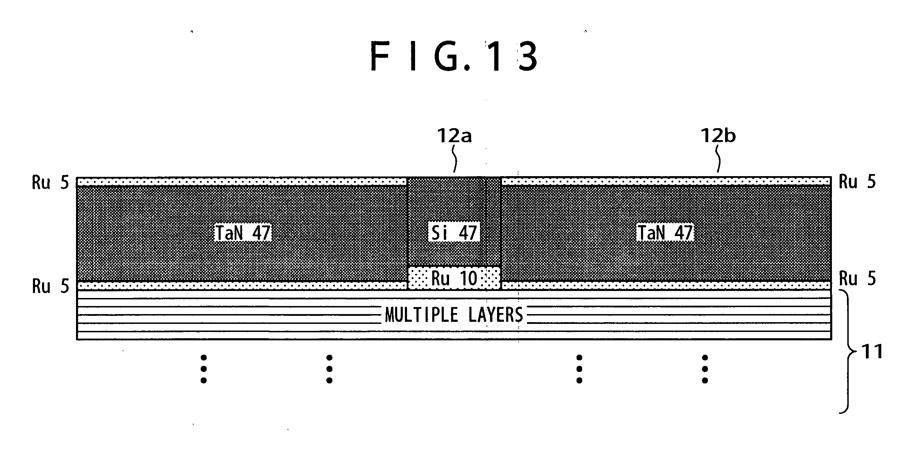

FIG. 13 is a schematic view showing a sectional structure of one constitution of the halftone phase shift mask. In the illustrated mask, the reflective mask blank with multilayered films 11 has thereon the first region 12a in which Ru of 10 nm and Si of 47 nm are multilayered in order, and the second region 12b in which Ru of 5 nm, TaN of 47 nm and Ru of 5 nm are multilayered in order. The reason for the use of the Si for the composing material of the formative film of the first region 12a is as follows. The complex refractive index of the Si is 0.99932 - 0.00182645i whose real part is extremely close to 1 specified as the refractive index in a vacuum and whose imaginary part is smaller than that of the other materials. Thus, a Si material is allowed to bear a role in the adjustment of the phase difference and the reflectance ratio by taking advantage of the multiple interference effect in film of the Si material. The application of the multiple interference effect in film makes it possible to constitute the halftone phase shift mask of a flat structure in which the first region 12 and the second region 12b create the phase difference of 180°, and besides, respectively have a completely flat upper surface.

(Second embodiment)

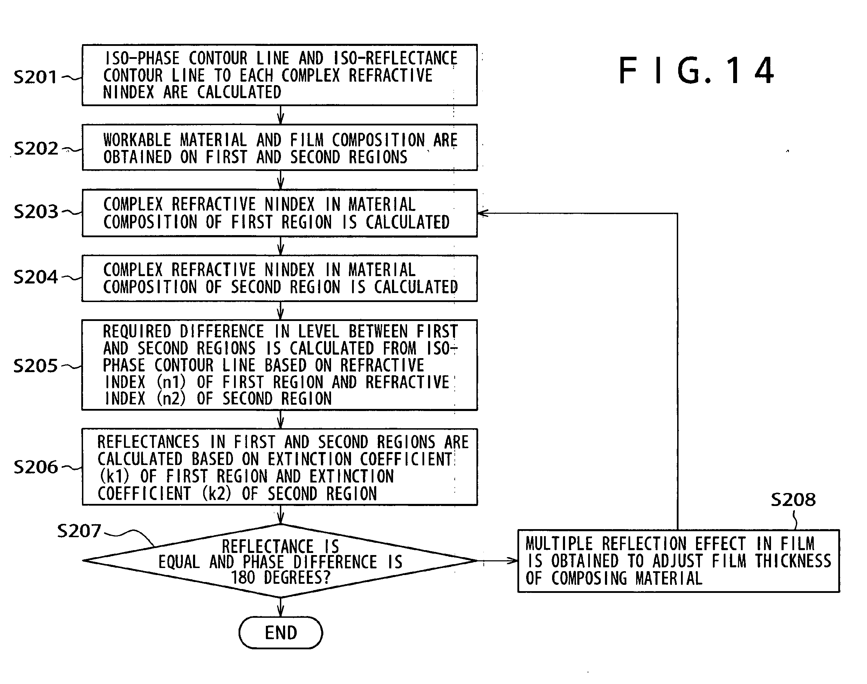

The second embodiment of the fabrication procedure of the phase shift mask is now described. A description of the second embodiment is given by taking the case where the present invention is applied to constitute a Levenson phase shift mask. FIG. 14 is a flowchart showing the fabrication procedure of the phase shift mask in the second embodiment.

As shown in FIG. 14, the fabrication of the Levenson phase shift mask is also performed approximately in the same manner (See FIG. 2) as that in the case of the halftone phase shift mask in the above first embodiment (S201 to S208). However, the Levenson phase shift mask is different from the halftone phase shift mask in that the former requires that not only the phases in the first region 12a and the second region 12b are different by 180°, but also the reflectance in the first region 12a and that in the second region 12b are approximately equal. That is, for constituting the Levenson phase shift mask, it is necessary to satisfy two requirements, that is, (1) the reflectance in the first region 12a and that in the second region 12b should be approximately equal, and (2) the phase difference between the first region 12a and the second region 12b should be 180° (S208).

A judgment as to whether or not these requirements are satisfied may be performed as follows. Firstly, assuming that the reflectance of the first region 12a is $R_1$, and the reflectance of the second region 12b is $R_2$, a reflectance ratio P obtained by the following expression (4) is specified.

$$P = (1 - R_1(\lambda) / R_2(\lambda)) \times 100 \ (\%) \tag{4}$$

Then, a criterion 1 of $|P| \leqq 3.0\%$ is applied to the specified reflectance ratio P, and when an agreement with the criterion 1 is reached, it is judged that the above requirement (1) is satisfied.

Further, with reference to the above requirement (2), a criterion 2 of $|\varphi(\lambda)| \leqq 6°$ is applied to $\varphi(\lambda)$ obtained by the expression (1) having been described in the first embodiment. Then, when an agreement with the criterion 2 is reached, it is judged that the above requirement (2) is satisfied.

The Levenson phase shift mask obtained in this manner is supposed to be available in the form of the constitution shown in FIG. 1A, that is, one in which both the first region 12a and the second region 12b have the buffer film 13 and the absorption film 14.

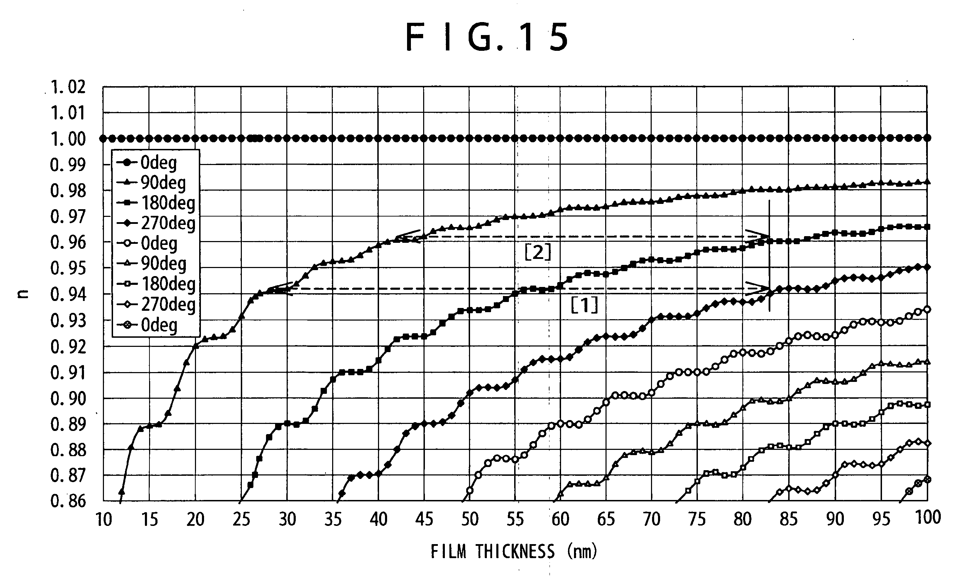

A fabrication procedure of the Levenson phase shift mask of the constitution shown in FIG. 1A is now described in more detail by taking a specific example. For constituting the Levenson phase shift mask, the calculation of the iso-phase contour line and the iso-reflectance contour line to the arbitrary complex refractive index is also firstly required, like the case of the halftone phase shift mask having been described in the first embodiment. FIG. 15 illustrates one specific instance of the iso-phase contour line. The illustrated iso-phase contour line is calculated by fixing the imaginary part (k) of the complex refractive index at 0.0100i.

By the way, the Levenson phase shift mask requires that a phase difference $\varphi_1(\lambda)$ between the formative film of the first region 12a and the reflective mask blank with multilayered films 11 is specified by the following expression (5).

$$\psi_1(\lambda) = \phi_1(\lambda) - \phi s(\lambda) + (4\pi h_1 \cos\theta)/\lambda \tag{5}$$

Further, a phase difference $\varphi_2$ between the formative film of the second region 12b and the reflective mask blank with multilayered films 11 is specified by the following expression (6).

$$\psi_2(\lambda)= \phi_2(\lambda)\text{-}\phi s(\lambda) + (4\pi h_2 \cos\theta)/\lambda \qquad (6)$$

Thus, a phase difference $\varphi(\lambda)$ between the first region 12a and the second region 12b is supposed to be specified by the following expression (7).

$$\psi(\lambda) = \psi_1(\lambda) - \psi_2(\lambda) \qquad (7)$$

A relation specified by the expression (7) is expressed in terms of a correlation of the iso-phase contour lines as shown in FIG. 15. In FIG. 15, it may be appreciated that the difference in the level between the first region 12a and the second region 12b requires 56 nm to satisfy the phase difference of 180° between the first region 12a and the second region 12b with the material whose real part of the complex refractive index is 0.94, for instance (See "1" in FIG. 15). Further, it may be also appreciated that the difference in the level between the first region 12a and the second region 12b requires 42 nm to satisfy the phase difference of 180° between the first region 12a and the second region 12b with the material whose real part of the complex refractive index is 0.96 in the first region 12a and 0.94 in the second region 12b (See "2" in FIG. 15). On the contrary, for the calculation of the reflectance, an absolute value to the total film thickness is used as it is, instead of a relative value.

The Levenson phase shift mask may be also constituted only by setting, based on the iso-phase contour line (See FIG. 15) and the iso-reflectance contour line (See FIG. 4) as described the above, the film thickness and the complex refractive index of the formative film so as to satisfy the criteria 1 and 2.

That is, the phase difference from the reflective mask blank with multilayered films 11 in the first region 12a is calculated from the film thickness and the real part of the complex refractive index of the group of the materials composing the first region 12a formed on the reflective mask blank with multilayered films 11, and the phase difference from the reflective mask blank with multilayered films in the second region 12b is calculated from the film thickness and the real part of the complex refractive index of the group of the materials composing the second region 12b formed on the reflective mask blank with multilayered films 11. Further, the reflectance in the first region 12a is calculated from the film thickness and the imaginary part of the complex refractive index of the group of the materials composing the first region 12a formed on the reflective mask blank with multilayered films 11, and the reflectance in the second region 12b is further calculated from the film thickness and the imaginary part of the complex refractive index of the group of the materials composing the second region 12b formed on the reflective mask blank with multilayered films 11. Then, these results are applied to obtain, as the Levenson phase shift mask, the constitution satisfying the criteria 1 and 2, that is, one in which the first region 12a and the second region 12b are different in the phase difference by 180°, and the reflectance in the first region 12a and that in the second region 12b are approximately equal. Incidentally, it does not matter if the calculation on which of the phase difference and the reflectance is performed earlier.

By the way, it is necessary to deposit the formative films of the first region 12a and the second region 12b with different materials arranged appropriately in multiple layers to satisfy the criteria 1 and 2 simultaneously. This is because the Levenson phase shift mask simultaneously satisfying the criteria 1 and 2 fails to be obtained as a practically easily fabricated structure due to limitations on the complex refractive index of the practically existing materials, unless the different materials are appropriately arranged in multiple layers.

For this reason, TaN, Ru and Si are used as the materials composing the first region 12a. Further, Mo and Ru are used as the materials composing the second region 12b. The reason for the use of these materials is that it is generally known that an etching selection ratio of each material is quite largely taken in a combination as described below, as disclosed in "Approach to patterning of extreme ultraviolet lithography masks" of Jpn. J. Appl. Phys, Vol. 40 (2001), pp. 6998 to 7001. That is, when an etching of the Ru layer to a Si substrate is performed by a dry etching with $Cl_2 + O_2$ gas, the Si substrate acts as an etching stopper on the Ru etching. When the etching of the TaN layer to the Ru substrate is performed by the dry etching with Ar + $Cl_2$ gas, the Ru substrate acts as the etching stopper on the TaN layer etching. Further, the etching of the Mo layer and the Si layer to the Ru substrate is also performed by the dry etching with the Ar + $Cl_2$ gas to largely take the selection ratio. This is because a Ru chloride $RuCl_3$ is a relatively stable substance which is supposed to be dissolved at 600 °C or above. On the contrary, a Si chloride $SiCl_4$ has a boiling point of 57.6 °C, a Mo chloride $MoCl_5$ has a boiling point of 268 °C, and a Ta chloride $TaCl_5$ has a boiling point of 242 °C, from which it may be seen that a removal as etching reaction gas in the vacuum to the Ru chloride is easily caused.

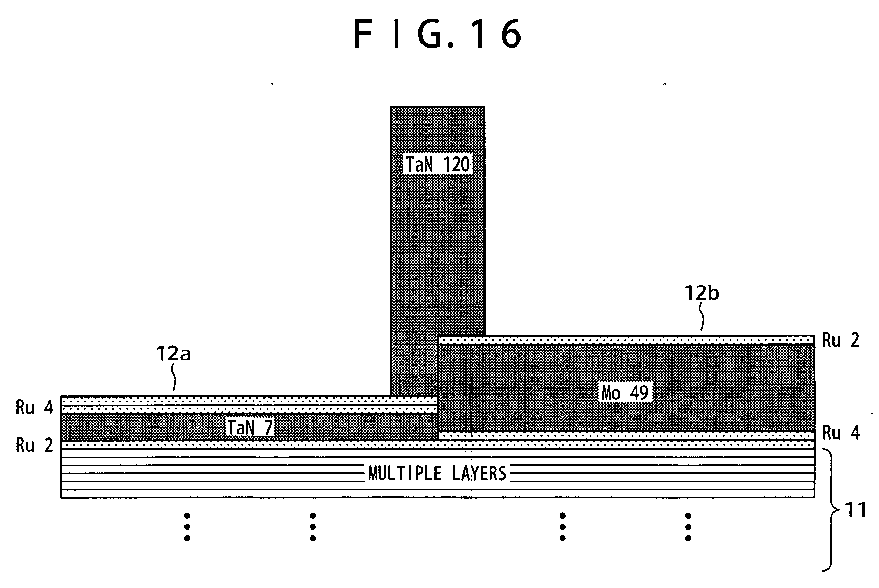

FIG. 16 is a schematic view showing a sectional structure of one constitution of the Levenson phase shift mask. The illustrated structure (which is hereinafter referred to as "a structure 1") is supposed to be one satisfying the criteria 1 and 2 determined based on the iso-phase contour line in FIG. 15 and the iso-reflectance contour line in FIG. 4. The first region 12a has, on the reflective mask blank with multilayered films 11, the formative film in the form of the multiple layers in the order of Ru of 2 nm, TaN of 7 nm and Ru of 4 nm. The first region 12a has the total film thickness of 11 nm, and shows the composite complex refractive index whose real part is 0.9165, and whose imaginary part is 0.02507i. Further, the second region 12b has the formative film in the form of the multiple layers in the order of Ru of 4 nm, Mo of 49 nm and Ru of 2 nm. The second region 12b has the total film thickness of 55 nm, and shows the composite complex refractive index whose real part is 0.9174 and whose imaginary part is 0.00764i. Incidentally, a boundary between the first region 12a and the second region 12b has a TaN absorption layer of 120 nm in the film thickness with a width of 40 nm.

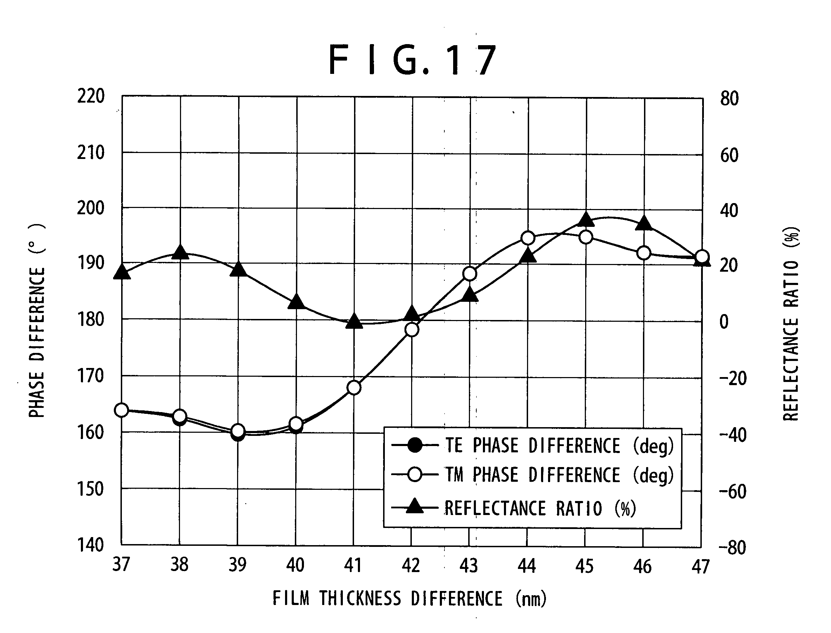

With reference to the above structure 1, the calculation of the difference in the level between the first region 12a and the second region 12b from the iso-phase contour line in FIG. 15 results in 43 nm of the above difference in the level based on a relation between the iso-phase contour lines of 90° and 270°, and similarly, 43 nm is also derived from the relation between the iso-phase contour lines of 180° and 0°. Further, according to an iso-transmittance contour line in FIG. 4, it may be also appreciated that the reflectance of the first region 12a is 0.39, and the reflectance of the second region 12b is 0.38. Then, a result as shown in FIG. 17, for instance, is obtained from the calculation of the phase difference and the reflectance ratio on the structure 1 by varying the Mo film thickness of the second region 12b inclusive of the multiple interference effect in film in detail. From the illustrated result, it may be confirmed that the structure 1 shown in FIG. 16 is in the form of an optimum constitution within a film thickness adjustment range of each material.

Further, in the structure 1, the reflectance is 0.0388 with respect to the first region 12a, and 0.387 with respect to the second region 12b, in which case, the reflectance ratio therebetween results in 0.258 %. Further, the phase difference between the first region 12a and the second region 12b reaches 178.8° with respect to a TE (Transverse Electric) wave, and 178.7° with respect to a TM (Transverse Magnetic) wave.

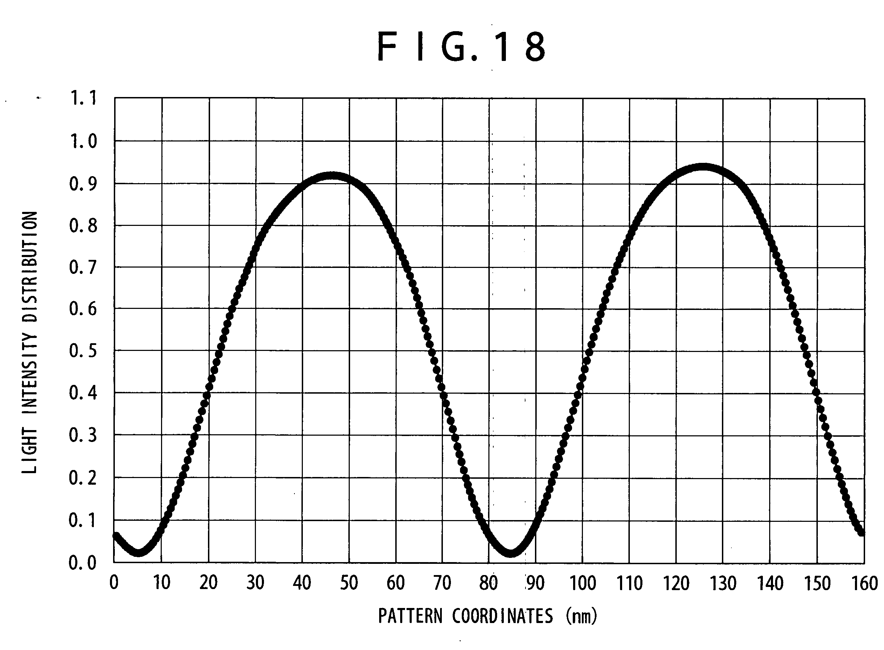

The light intensity distribution in the case of the use of the Levenson phase shift mask of the above structure 1 is supposed to produce a result as shown in FIG. 18, for instance, when the optical conditions of NA = 0.25 and $\sigma$ = 0.70 are applied to the case of the exposure of the wafer to the light with the 120 nm-thick TaN absorption layer formed as wide as 40 nm (10 nm in terms of a wafer unit) on the four-fold mask of the structure 1.

Further, 180° of the phase difference between the first region 12a and the second region 12b may be confirmed by the calculation of the phase difference according to the following expression (8) using a 320 nm-pitch (a 80 nm-pitch to the width of 10 nm in terms of the wafer unit) pattern with the TaN absorption layer having the width of 40 nm. Incidentally, the expression (8) employs coordinates on the wafer. An X-axis is expressed in terms of nm unit.

$$\varphi = I(x + 80) - I(x) \ (0 \leq x \leq 80) \tag{8}$$

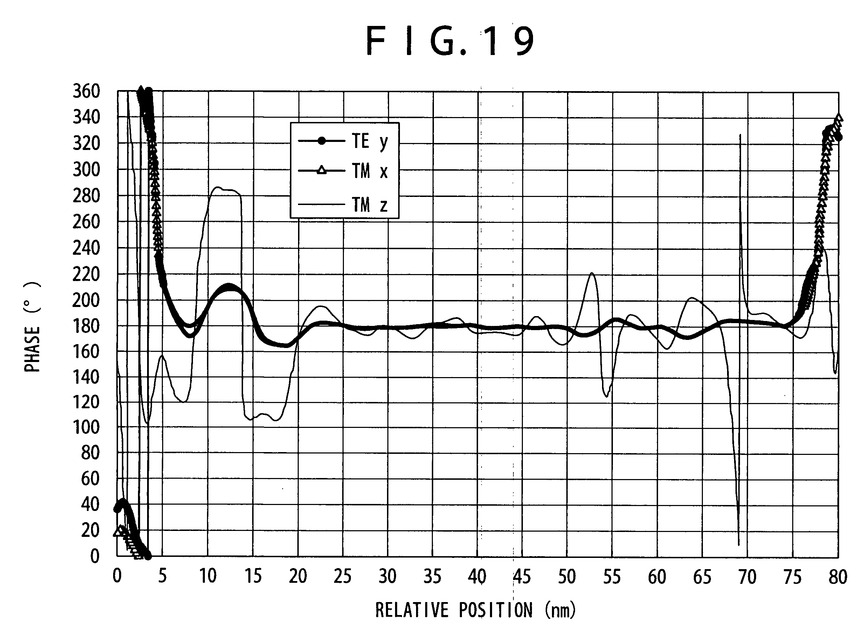

FIG. 19 shows a result of the calculation of the expression (8) on a position right above the mask to a TEy wave, a TMx wave and a TMz wave. According to this illustration, both the TEy wave and the TMx wave satisfactorily hold the phase difference of 180°. On the contrary, the TMz wave shows a more outstanding deviation from 180°, in which case, however, a contribution toward a transfer is as small as about 0.45 %, resulting in no effect on the transfer.

For the above reasons, it may be said that the Levenson phase shift mask of the structure 1 satisfies the criteria 1 and 2 simultaneously to ensure that the reflectance in the first region 12a and that in the second region 12b are approximately equal and the phase difference between the first and the second regions is 180°.

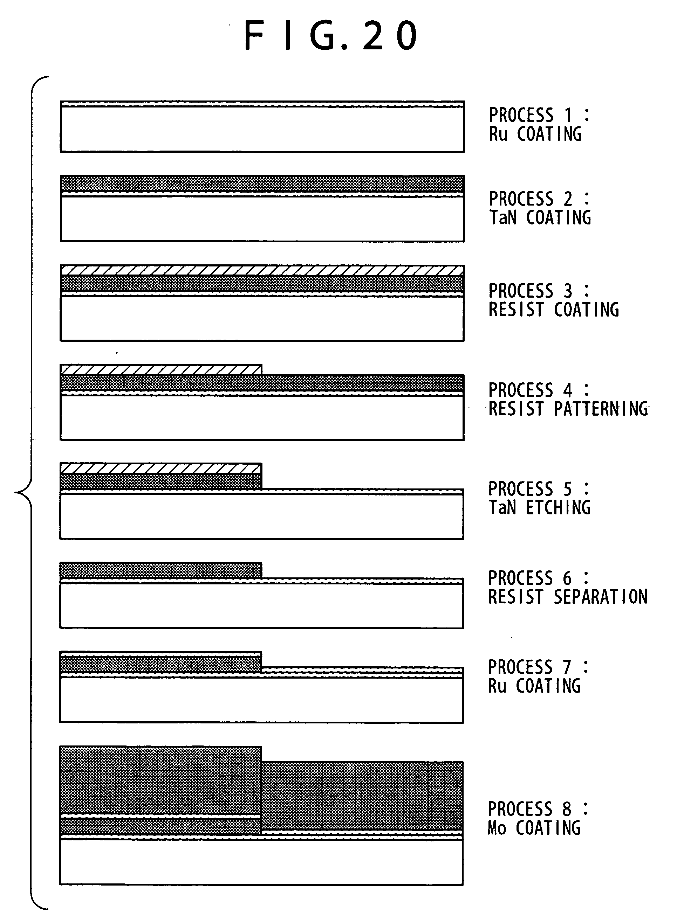

A procedure required when depositing, on the reflective mask blank with multilayered films 11, the formative films of the first and the second regions 12a and 12b respectively obtained after the setting of the complex refractive index and the film thickness as described the above is now described in brief. FIGS. 20 to 23 illustrate one instance of a deposition procedure of the structure 1. For the deposition of the formative films according to the structure 1, the Ru layer is firstly deposited on the reflective mask blank with multilayered films 11 by a sputtering, as shown in FIG. 20 (a process 1). The Ru layer is supposed to be a material ordinarily available as the buffer layer in the binary mask, so that the same fabrication apparatus as that required for the ordinary case may be used. Then, the TaN layer is deposited on the Ru layer by the sputtering (a process 2). The TaN layer is supposed to be the material available as the absorption layer in the binary mask, so that the same fabrication apparatus as that required for the ordinary case may be used.

Thereafter, the TaN layer is coated with a resist (a process 3), and a removal of the resist from a second region 12b portion is performed by way of a patterning and a resist development (a process 4). After the removal of the resist, the TaN layer is removed from the second region 12b portion by the dry etching with the Ar + $Cl_2$ gas (a process 5). The Ru layer beneath the etched TaN layer is supposed to function as an etching stopper layer. Then, the resist is separated (a process 6), and the deposition of the Ru layer again by the sputtering (a process 7) is performed and is followed by the deposition of the Mo layer this time by the sputtering (a process 8). The Mo layer is supposed to be the composing material of the reflective mask blank with multilayered films 11, so that a multilayer fabrication apparatus may be used.

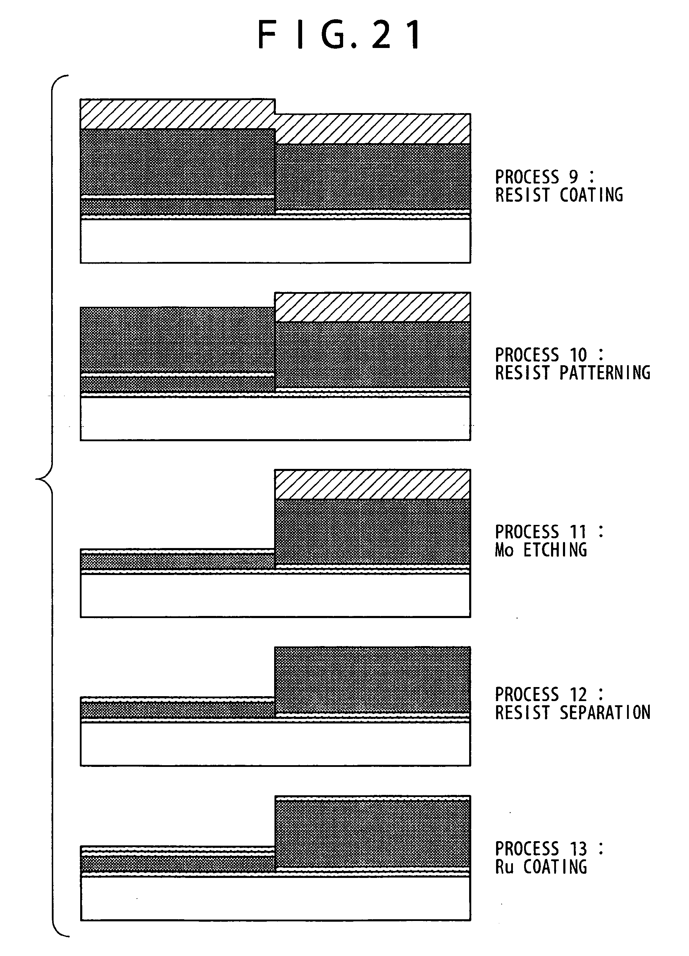

The deposition of the Mo layer is followed by the coating of the resist (a process 9) as shown in FIG. 21, and the removal of the resist from a first region 12a portion is performed by way of the patterning and the resist development (a process 10). Then, the Mo layer is removed from the first region 12a portion by the dry etching with the Ar + $Cl_2$ gas (a process 11). The Ru layer beneath the etched Mo layer is supposed to function as the etching stopper layer. Thereafter, the resist is separated (a process 12), and the Ru layer is deposited again by the sputtering (a process 13).

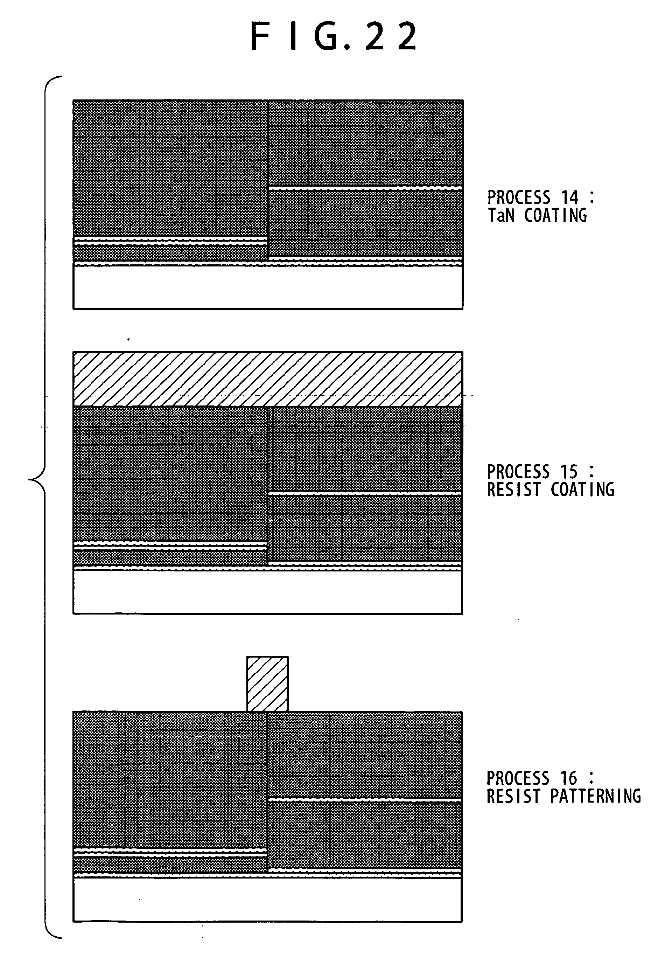

The deposition of the Ru layer is followed by the deposition of the TaN absorption layer by the sputtering as shown in FIG. 22 (a process 14), and the coating of the resist further follows (a process 15). Then, the removal of the resist from a portion other than a portion left as the absorption layer is performed by way of the patterning and the resist development (a process 16).

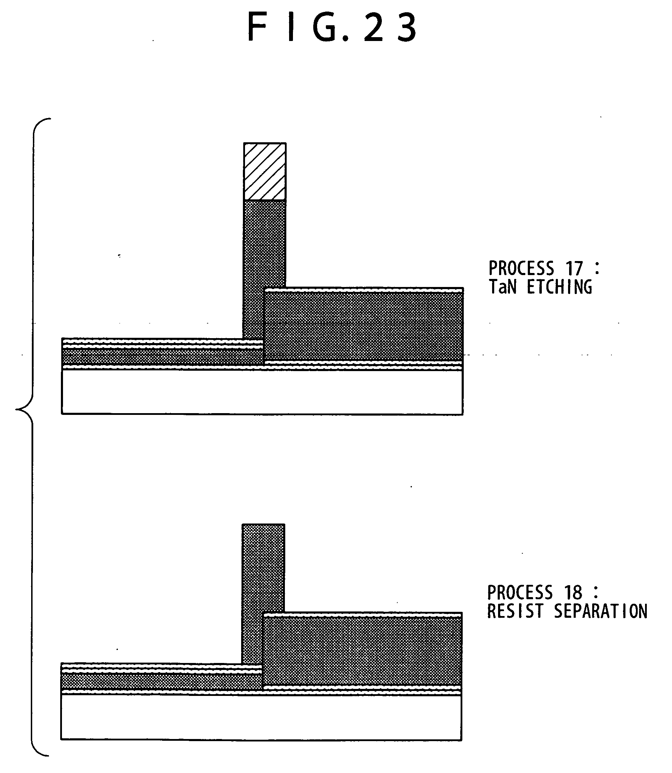

Thereafter, the TaN absorption layer is removed by the dry etching with the Al + $Cl_2$ gas as shown in FIG. 23 (a process 17). The Ru layer beneath the etched TaN layer is supposed to function as the etching stopper layer. Then, a separation of the resist (a process 18) is performed, leading to a completion of the Levenson phase shift mask of the structure 1 with the effective use of the Ru layer as the etching stopper layer.

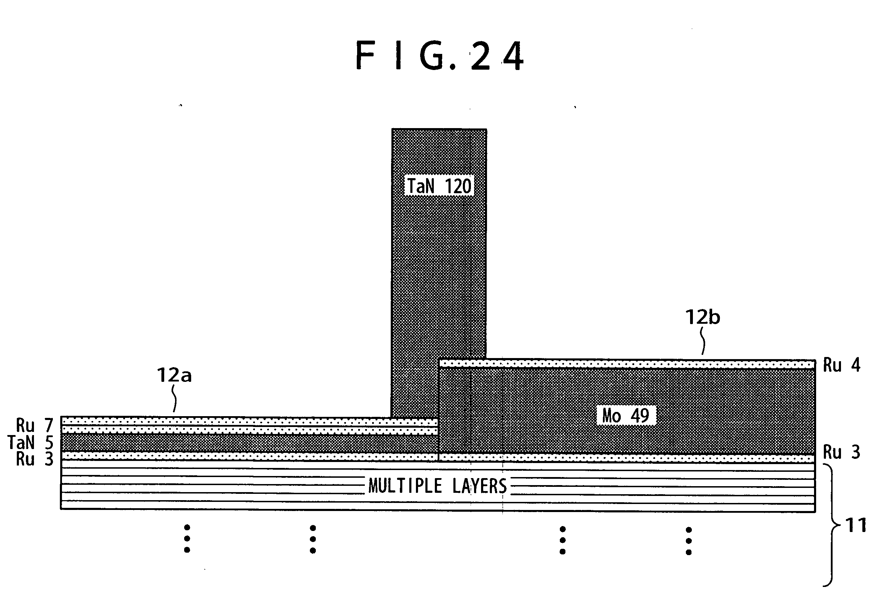

FIG. 24 is a schematic view showing a sectional structure of a different constitution of the Levenson phase shift mask. The illustrated structure (which will be hereinafter referred to as "a structure 2") is supposed to be one satisfying the criteria 1 and 2 determined based on the iso-phase contour line in FIG. 15 and the iso-reflectance contour line in FIG. 4, likewise the above structure 1. The first region 12a has, on the reflective mask blank with multilayered films 11, the formative film in the form of the multiple layers in the order of Ru of 3 nm, TaN of 5 nm and Ru of 7 nm. The first region 12a has the total film thickness of 15 nm, and shows the composite complex refractive index whose real part is 0.9054 and whose imaginary part is 0.02217i. Further, the second region 12b has the formative film in the form of the multiple layers in the order of Ru of 3 nm, Mo of 49 nm and Ru of 4 nm. The second region 12b has the total film thickness of 56 nm, and shows the composite complex refractive index whose real part is 0.9169 and whose imaginary part is 0.00782i.

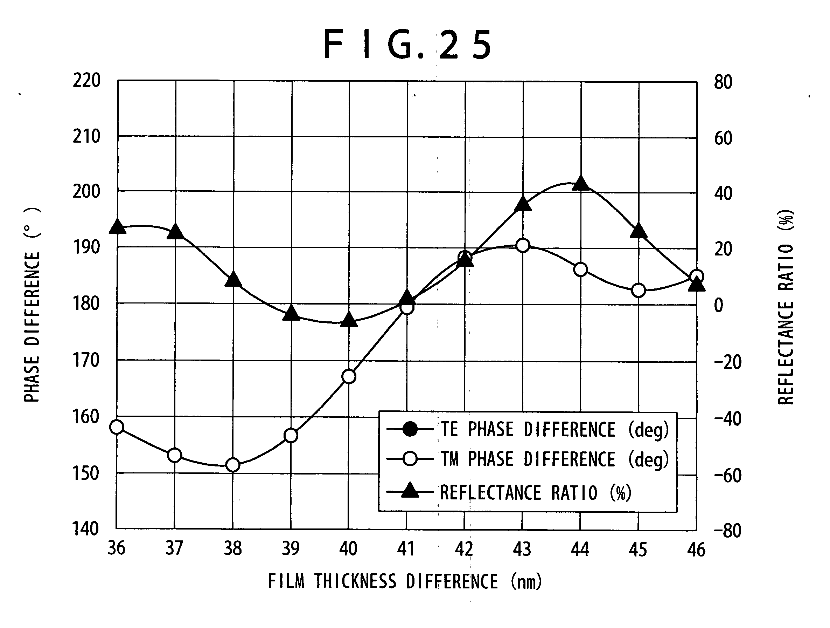

With reference to the structure 2 as described the above, the calculation of the difference in the level between the first region 12a and the second region 12b from the iso-phase contour line in FIG. 15 results in 44 nm of the above difference in the level based on the relation between the iso-phase contour lines of 90° and 270°, and similarly, 44 nm is also derived from the relation between the iso-phase contour lines of 180° and 0°. Further, according to the iso-transmittance contour line in FIG. 4, it may be also appreciated that the reflectance of the first region 12a is 0.38, and the reflectance of the second region 12b is 0.36. Then, a result as shown in FIG. 25, for instance, is obtained from the calculation of the phase difference and the reflectance ratio on the structure 2 by varying the Mo film thickness of the second region 12b inclusive of the multiple interference effect in film in detail. From the illustrated result, it may be confirmed that the structure 2 shown in FIG. 24 is supposed to be in the form of the optimum constitution within the film thickness adjustment range of each material.

Further, in the structure 2, the reflectance is 0.399 with respect to the first region 12a, and 0.396 with respect to the second region 12b, in which case, the reflectance ratio therebetween results in 0.710 %. Thus, the phase difference between the first region 12a and the second region 12b reaches 178.2° with respect to the TE wave and 178.3° with respect to the TM wave.

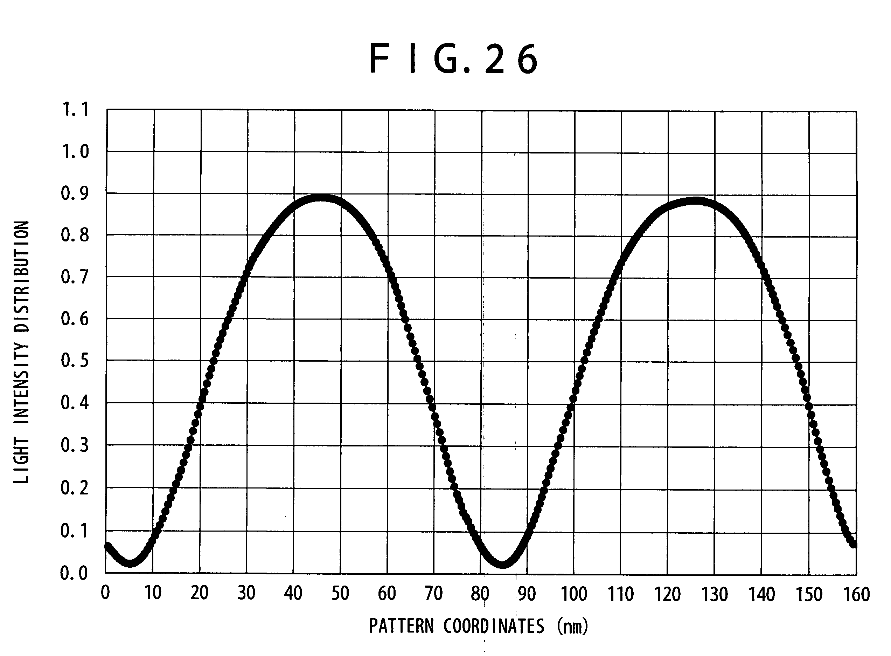

The light intensity distribution in the case of the use of the Levenson phase shift mask of the above structure 2 is supposed to produce a result as shown in FIG. 26, for instance, when the optical conditions of NA = 0.25 and σ = 0.70 are applied to the case of the exposure of the wafer to the light with the 120 nm-thick TaN absorption layer formed as wide as 40 nm (10 nm in terms of the wafer unit) on the four-fold mask of the structure 2.

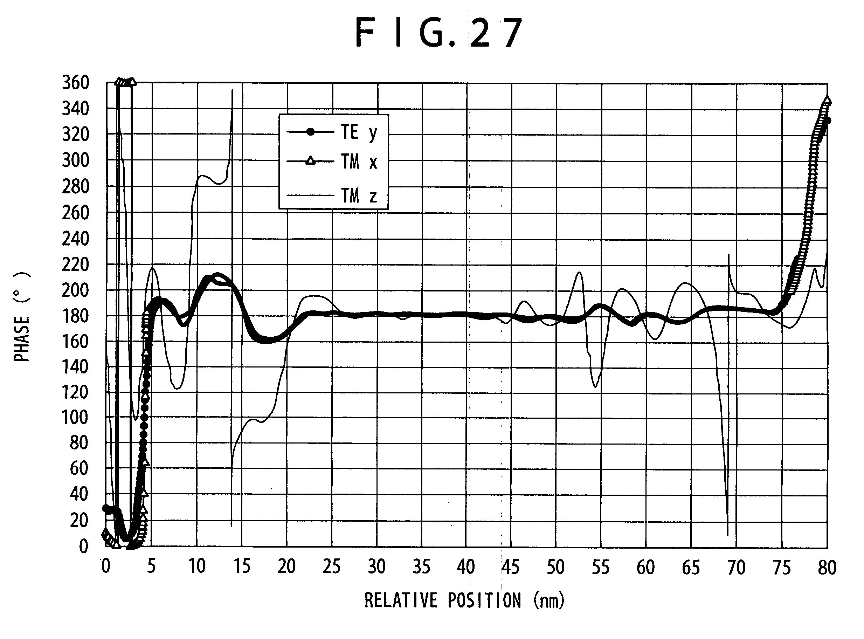

Further, 180° of the phase difference between the first region 12a and the second region 12b may be confirmed by calculating the phase difference according to the above expression (8) using the 320 nm-pitch (the 80 nm-pitch to the width of 10 nm in terms of the wafer unit) pattern with the TaN absorption layer having the width of 40 nm. FIG. 27 shows a result of the calculation of the expression (8) on the position right above the mask to the TEy wave, the TMx wave and the TMz wave. According to this illustration, both the TEy wave and the TMx wave satisfactorily hold the phase difference of 180°. On the contrary, the TMz wave shows the more outstanding deviation from 180°, in which case, however, the contribution toward the transfer is as small as about 0.45 %, resulting in no effect on the transfer.

The deposition procedure of the structure 2 obtained after the setting of the complex refractive index and the film thickness as described the above is approximately the same as that in the case of the above structure 1. The deposition procedure of the structure 2 is different from that of the structure 1 in that the former procedure additionally requires, between the processes 5 and 6, a process of removing the Ru layer from the second region 12b portion by the dry etching with $Cl_2$ + $O_2$ gas.

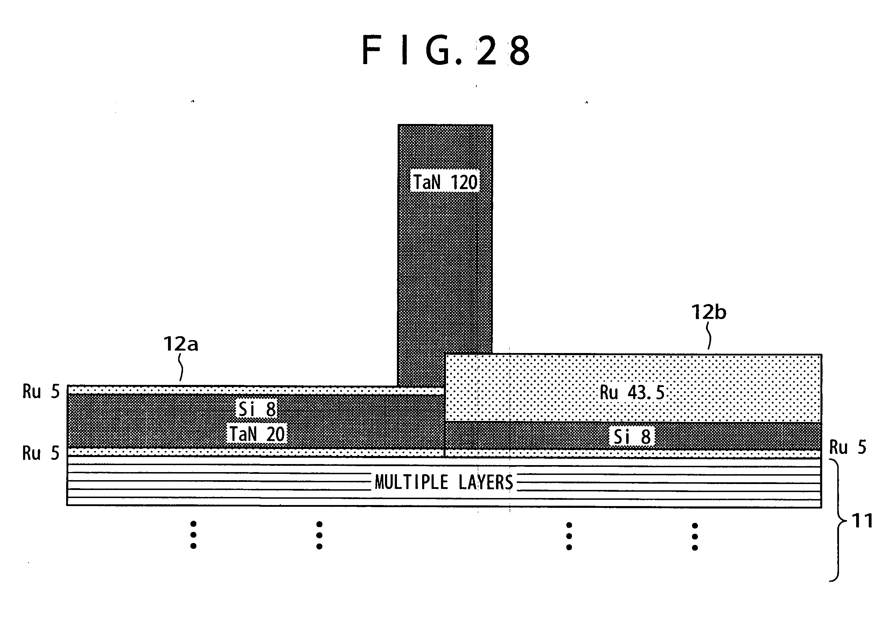

FIG. 28 is a schematic view showing a further different constitution of the Levenson phase shift mask. The illustrated structure (which will be hereinafter referred to as "a structure 3") is supposed to be one satisfying the criteria 1 and 2 determined based on the iso-phase contour line in FIG. 15 and the iso-reflectance contour line in FIG. 4, likewise the above structures 1 and 2. The first region 12a has, on the reflective mask blank with multilayered films 11, the formative film in the form of the multiple layers in the order of Ru of 5 nm, TaN of 20 nm, Si of 8 nm and Ru of 5 nm. Further, the second region 12b has the formative film in the form of the multiple layers in the order of Ru of 5 nm, Si of 8 nm and Ru of 43.5 nm.

In the above structure 3, the Si is used as the composing material of the formative films of the first and the second regions 12a and 12b, unlike the case of the structure 1 or 2. The complex refractive index of the Si is 0.99932 - 0.00182645i whose real part is extremely close to 1 specified as the refractive index in the vacuum and whose imaginary part is smaller than that of the other materials. Thus, the Si material is allowed to bear the role in the adjustment of the phase difference and the reflectance ratio by taking advantage of the multiple interference effect in film.

Thus, the constitution satisfying the criteria 1 and 2 may be obtained from the iso-phase contour line in FIG. 15 and the iso-reflectance contour line in FIG. 4 by taking a procedure of extracting a condition for preponderantly narrowing down the adjustment to the phase difference without taking the Si layer into consideration, and of then adjusting the phase difference to reach close to 180°, while narrowing down the adjustment to the reflectance with the multiple interference effect in film of the Si layer. That is, the constitution satisfying the criteria 1 and 2 is supposed to be in the form of the multiple layers in the order of Ru of 5 nm, TaN of 20 nm and Ru of 5 nm on the reflective mask blank with multilayered films 11 as for the first region 12a, and in the form of the multiple layers in the order of Ru of 5 nm and Ru of 43.5 nm as for the second region 12a. The first region 12a in this case has the total film thickness of 30 nm, and shows the composite complex refractive index whose real part is 0.9234 and whose imaginary part is 0.02687i. The second region 12b has the total film thickness of 48.5 nm, and shows the composite complex refractive index whose real part is 0.8875 and whose imaginary part is 0.01747i.

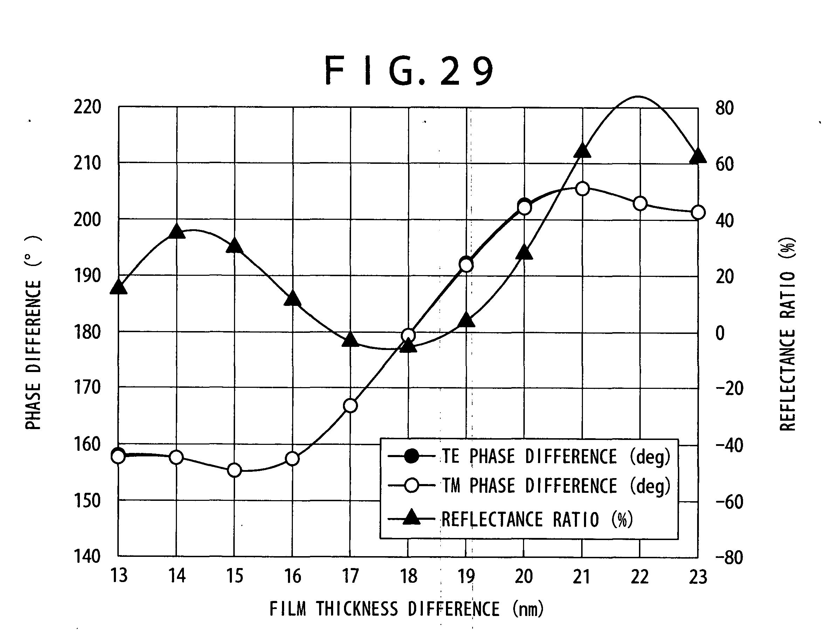

With reference to the above structure 3, the calculation of the difference in the level between the first region 12a and the second region 12b from the iso-phase contour line in FIG. 15 results in 22 nm of the above difference in the level based on the relation between the iso-phase contour lines of 90° and 27°, and similarly, 16 nm is derived from the relation between the iso-phase contour lines of 180° and 0°. Further, according to the iso-transmittance contour line in FIG. 4, it may be also appreciated that the reflectance of the first region 12a is 0.14 and the reflectance of the second region 12b is 0.18. Then, a result as shown in FIG. 29, for instance, is obtained from the calculation of the phase difference and the reflectance ratio on the structure 3 by varying the Mo film thickness of the second region 12b inclusive of the multiple interference effect in film in detail. From the illustrated result, it may be confirmed that the structure 3 shown in FIG. 28 is supposed to be in the form of the optimum constitution within the film thickness adjustment range of each material. The structure 3 employs the Si as the composing material of,the formative films of the first and the second regions 12a and 12b, and also takes advantage of the multiple interference effect in film obtained with the Si layer effectively, resulting in an attainment of the conditions under which the phase difference and the reflectance ratio satisfy the reference values.

Further, in the structure 3, the reflectance is 0.195 with respect to the first region 12a and 0.200 with respect to the second region 12b, in which case, the reflectance ratio therebetween results in 2.41 %. Thus, the phase difference between the first region 12a and the second region 12b reaches 185.3° with respect to the TE wave and 185.1° with respect to the TM wave.

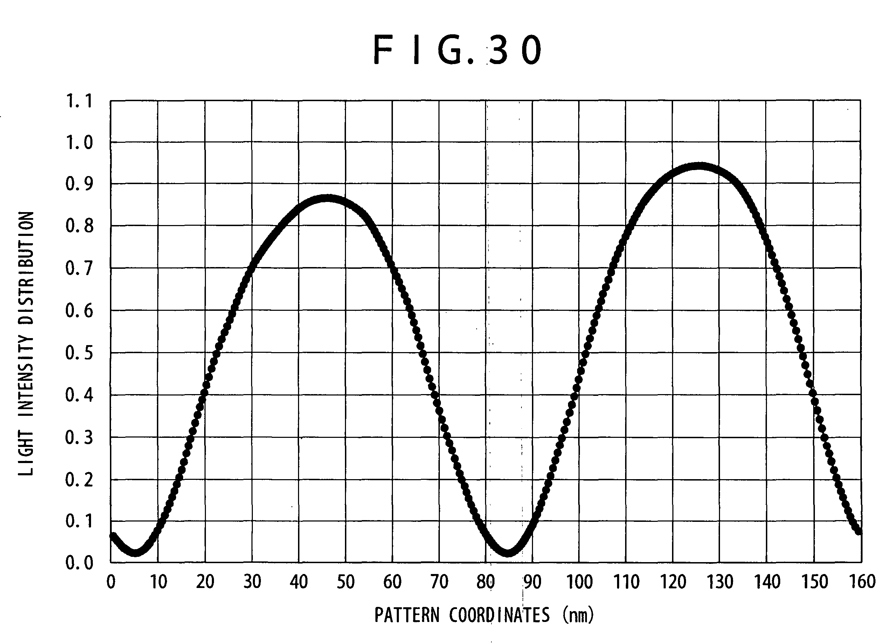

The light intensity distribution in the case of the use of the Levenson phase shift mask of the above structure 3 is supposed to produce a result as shown in FIG. 30, for instance, when the optical conditions of NA = 0.25 and σ = 0.70 are applied to the case of the exposure of the wafer to the light with the 120 nm-thick TaN absorption layer formed as wide as 40 nm (10 nm in terms of the wafer unit) on the four-fold mask of the structure 3.

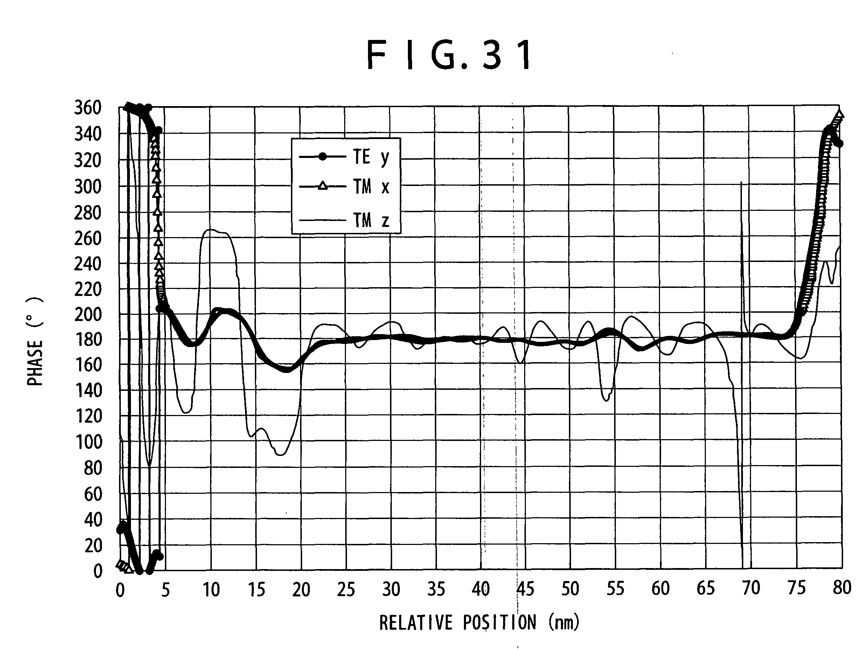

Further, 180° of the phase difference between the first region 12a and the second region 12b may be confirmed by calculating the phase difference according to the above expression (8) using the 320 nm-pitch (the 80 nm-pitch to the width of 80 nm in terms of the wafer unit) pattern with the TaN absorption layer having the width of 40 nm. FIG. 31 shows a result of the calculation of the above expression (8) on the position right above the mask to the TEy wave, the TMx wave and the TMz wave. According to this illustration, both the TEy wave and the TMx wave satisfactorily hold the phase difference of 180°. On the contrary, the TMz wave shows the more outstanding deviation from 180°, in which case, however, the contribution toward the transfer is as small as about 0.45 %, resulting in no effect on the transfer.

The deposition procedure of the structure 3 obtained after the setting of the complex refractive index and the film thickness as described the above is also approximately the same as that in the case of the above structure 2. The procedure of the structure 3 is different from that of the structure 2 in that the process 8 in the former procedure requires the deposition of the Si layer and the Ru layer by the sputtering, instead of the Mo layer.

By the way, each of the structures 1 to 3 has the difference in the thickness of the formative film between the first and the second regions 12a and 12b, resulting in the creation of the difference in the level of the formative film between the first and the second regions. The constitution described the above is also supposed to enable the phase shift effect to be obtained as described the above. However, with the considerations of the TaN absorption layer formed in the boundary between the first and the second regions 12a and 12b, it is more preferable that the first and the second regions 12a and 12b are formed flat without having the difference in the level, in view of an easiness in the fabrication. Thus, a specific instance of the constitution in which both the first and the second regions 12a and 12b are in the flat form is now described.

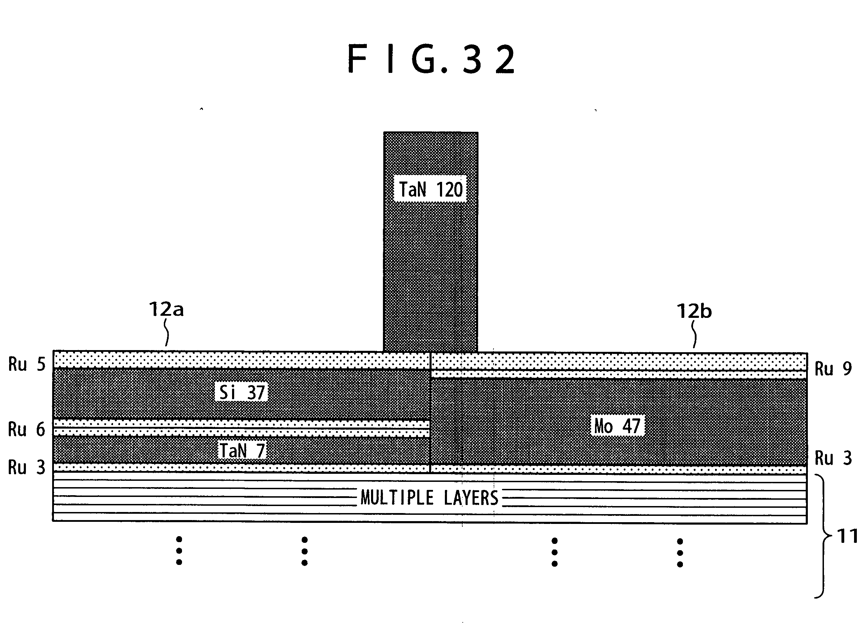

FIG. 32 is a schematic view showing a sectional structure of one flat constitution of the Levenson phase shift mask. The illustrated structure (which will be hereinafter referred to as "a structure 4") is supposed to be one satisfying the criteria 1 and 2 set based on the iso-phase contour line in FIG. 15 and the iso-reflectance contour line in FIG. 4. The first region 12a has, on the reflective mask blank with multilayered films 11, the formative film in the form of the multiple layers in the order of Ru of 3 nm, TaN of 7 nm, Ru of 6 nm, Si of 37 nm and Ru of 5 nm. Further, the second region 12b has the formative film in the form of the multiple layers in the order of Ru of 3 nm, Mo of 47 nm and Ru of 8 nm.

In the above structure 4, the reason for the use of the Si for the composing material of the formative film of the first region 12a is to allow the Si to bear the role in the adjustment of the phase difference and the reflectance ratio by taking advantage of the multiple interference effect in film, likewise the case of the structure 3. Thus, the constitution satisfying the criteria 1 and 2 may be obtained from the iso-phase contour line in FIG. 15 and the iso-reflectance contour line in FIG. 4 by taking the procedure of extracting the condition for preponderantly narrowing down the adjustment to the phase difference without taking the Si layer into consideration and of then adjusting the phase difference to reach close to 180°, while narrowing down the adjustment to the reflectance with the multiple interference effect in film of the Si layer. That is, the constitution satisfying the criteria 1 and 2 is supposed to be in the form of the multiple layers in the order of Ru of 3 nm, TaN of 7 nm, Ru of 6 nm and Ru of 5 nm on the reflective mask blank with multilayered films 11 as for the first region 12a, and in the form of the multiple layers in the order of Ru of 3 nm, Mo of 47 nm and Ru of 8 nm as for the second region 12b. The first region 12a in this case has the total film thickness of 21 nm, and shows the composite complex refractive index whose real part is 0.9054 and whose imaginary part is 0.03631i. The second region 12b has the total film thickness of 58 nm, and shows the composite complex refractive index whose real part is 0.9147 and whose imaginary part is 0.000904i.

With reference to the above structure 4, the calculation of the difference in the level between the first region 12a and the second region 12b from the iso-phase contour line in FIG. 15 results in 40 nm of the above difference in the level from the relation between the iso-phase contour lines of 90° and 270°, and similarly, 43 nm is derived from the relation between the iso-phase contour lines of 180° and 0°. Further, according to the iso-transmittance contour line in FIG. 4, it may be also appreciated that the reflectance of the first region 12a is 0.15 and the reflectance of the second region 12b is 0.30.

As described the above, the above structure 4, although being supposed to be the same as the structures 1 and 2 without considerations of the Si layer, causes a disagreement in the reflectance between the first region 12a and the second region 12b. To eliminate the above disagreement, the structure 4 matches the reflectance in the first region 12a and that in the second region 12b by inserting the Si layer to take advantage of the multiple interference in film effectively.

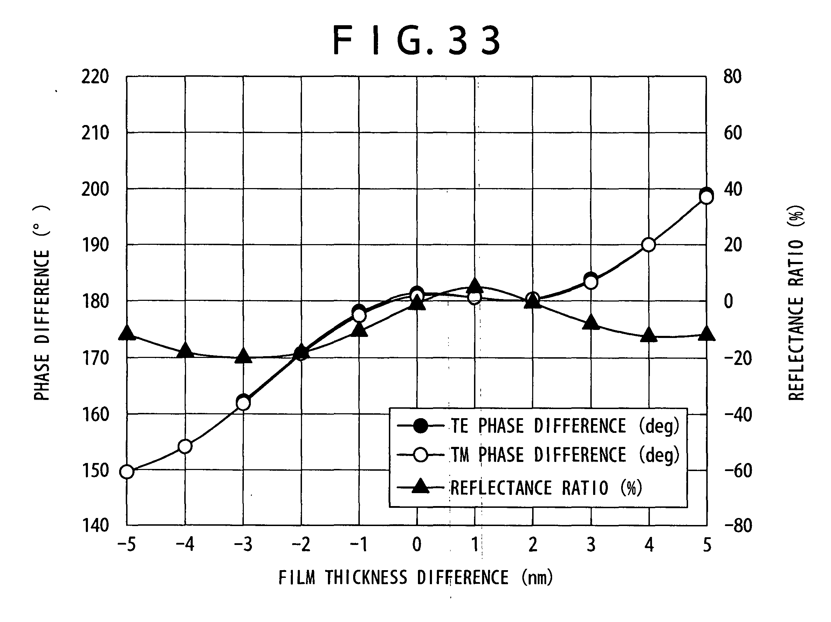

Thus, the structure 4 requires that the constitution satisfying the criteria 1 and 2 is obtained by appropriately varying the film thickness of the TaN layer of the first region 12a, the film thickness of the Mo layer of the second region 12b and the film thickness of the Si layer of the first region 12b. FIG. 33 shows a result obtained from the calculation of the phase difference and the reflectance ratio using the film thickness of the Mo layer as a parameter, with the film thickness of the TaN layer and the film thickness of the Si layer fixed. From the illustrated result, it may be confirmed that the structure 4 shown in FIG. 32 is supposed to be in the form of the constitution satisfying the criteria, provided that the difference in the film thickness between the first region 12a and the second region 12b reaches 0 nm. The structure 4 employs the Si as the composing material of the formative film of the first region 12a, and takes advantage of the multiple interference in film of the Si layer effectively, resulting in the attainment of the constitution in which the phase difference and the reflectance ratio satisfy the reference values and both the first region 12a and the second region 12b are in the flat form.

Further, in the structure 4, the reflectance is 0.285 with respect to the first region 12a and 0.287 with respect to the second region 12b, in which case, the reflectance ratio therebetween results in 0.65 %. Thus, the phase difference between the first region 12a and the second region 12b reaches 180.8° with respect to the TE wave, and 180.5° with respect to the TM wave.

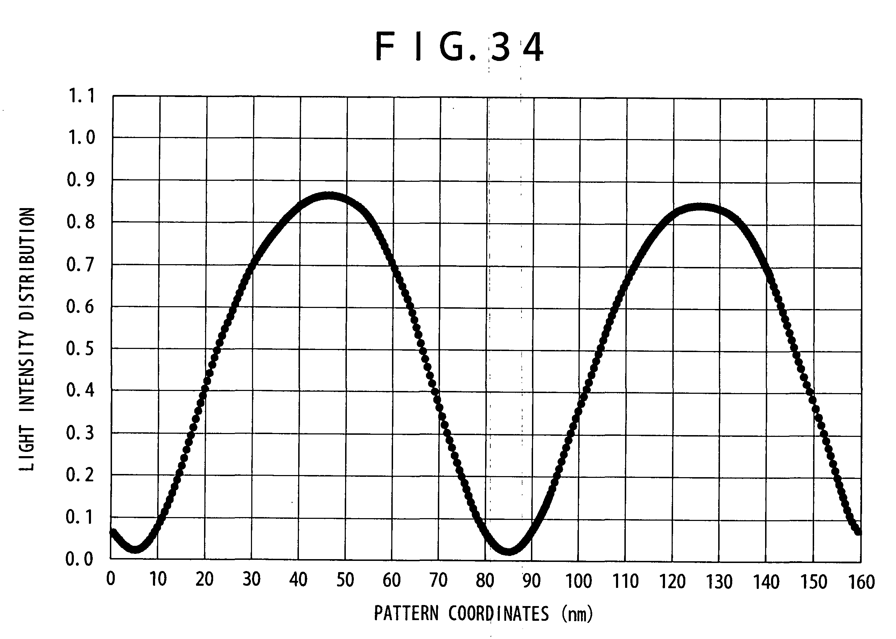

The light intensity distribution in the case of the use of the Levenson phase shift mask of the above structure 4 is supposed to produce a result as shown in FIG. 34, for instance, when the optical conditions of NA = 0.25 and σ of 0.70 are applied to the case of the exposure of the wafer to the light with the 120 nm-thick TaN absorption layer formed as wide as 40 nm (10 nm in terms of the wafer unit) on the four-fold mask of the structure 4.

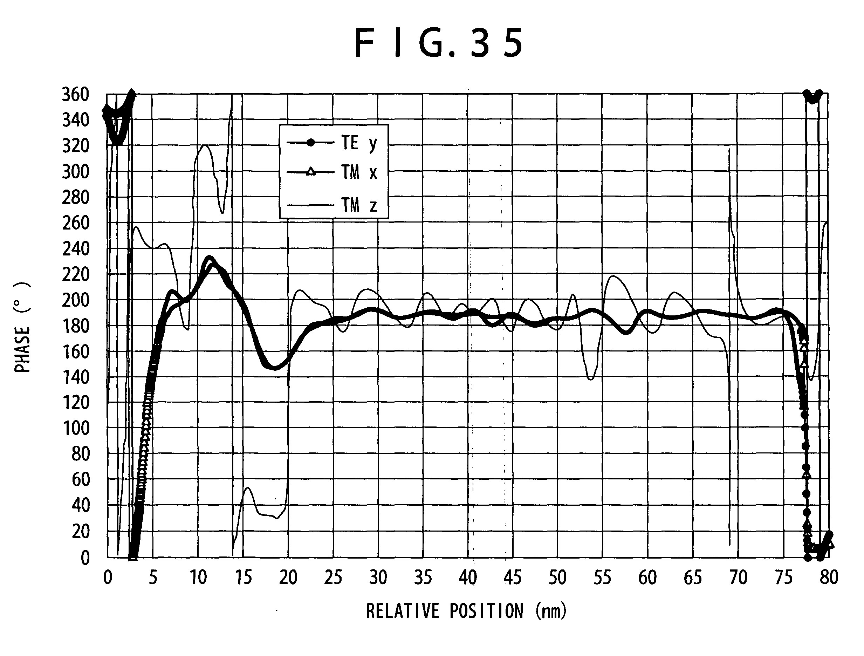

Further, 180° of the phase difference between the first region 12a and the second region 12b may be confirmed by calculating the phase difference according to the above expression (8) using the 320 nm-pitch pattern (the 80 nm-pitch to the width of 10 nm in terms of the wafer unit) pattern with the TaN absorption layer having the width of 40 nm. FIG. 35 shows a result of the calculation of the expression (8) on the position right above the mask to the TEy wave, the TMx wave and the TMz wave. According to this illustration, both the TEy wave and the TMx wave satisfactorily hold the phase difference of 180°. On the contrary, the TMz wave shows the more outstanding deviation from 180°, in which case, however, the contribution toward the transfer is as small as about 0.45 %, resulting in no effect on the transfer.

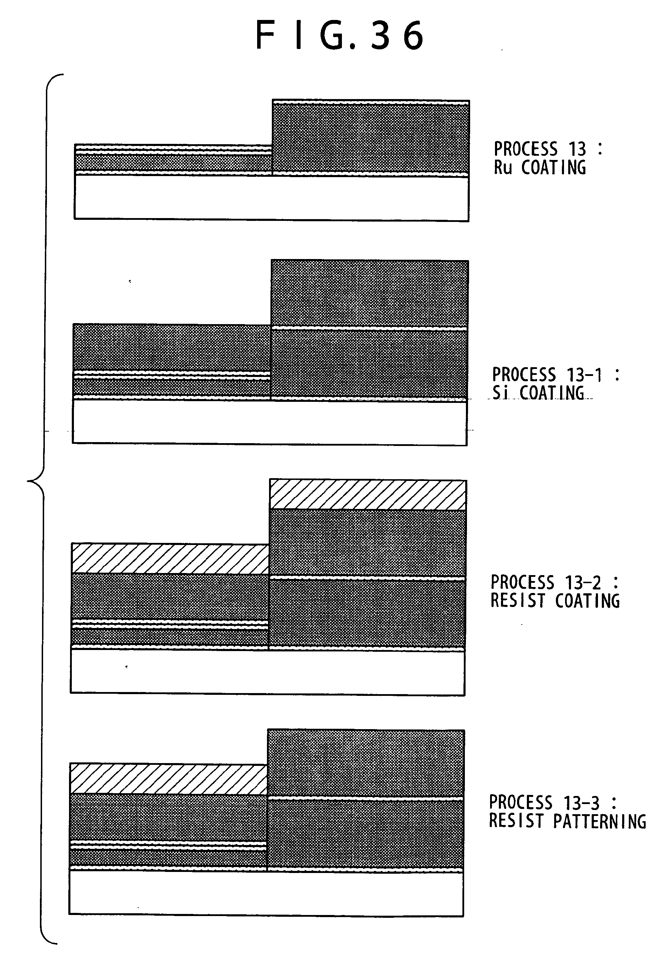

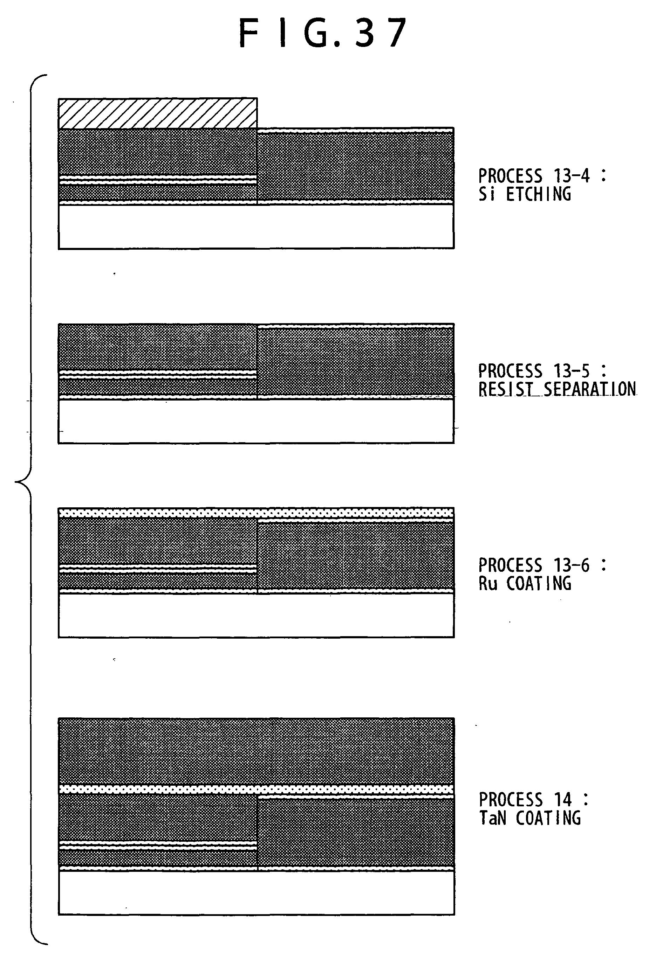

The deposition procedure of the structure 4 obtained after the setting of the complex refractive index and the film thickness as described the above may take, between the processes 5 and 6, a process of removing the Ru layer from the second region 12b portion by the dry etching with the $Cl_2 + O_2$ gas, likewise the case of the structure 2, and also requires processes as shown in FIGS. 36 and 37 between the processes 13 and 14, in addition to the processes in the case of the above structure 1 (See FIGS. 20 to 23).

That is, as shown in FIG. 36, the deposition of the Ru layer in the process 13 is followed by the deposition of the Si layer by the sputtering (a process 13-1), and the coating of the resist further follows (a process 13-2). Then, the removal of the resist from the second region 12b portion is performed by way of the patterning and the resist development (a process 13-3).

Thereafter, as shown in FIG. 37, the Si film is removed from the second region 12b portion by the dry etching with the $Ar + Cl_2$ gas (a process 13-4). The Ru layer beneath the etched Si layer is supposed to function as the etching stopper layer. Then, the separation of the resist (a process 13-5) and the deposition of the Ru layer by the sputtering (a process 13-6) are followed by the deposition of the TaN absorption layer by the sputtering (a process 14), and, thereafter, the processes similar to those in the case of the structure 1 follow. The above deposition procedure enables the Levenson phase shift mask of the structure 4 to be constituted.

As described the above, with reference to the structure 4, the constitution satisfying the criteria 1 and 2 and having the first and the second regions 12a and 12b in the flat form is specified by appropriately varying the film thickness of the TaN layer of the first region 12a, the film thickness of the Mo layer of the second region 12b and the film thickness of the Si layer of the first region 12. However, the above constitution may be also obtained in the following structure.

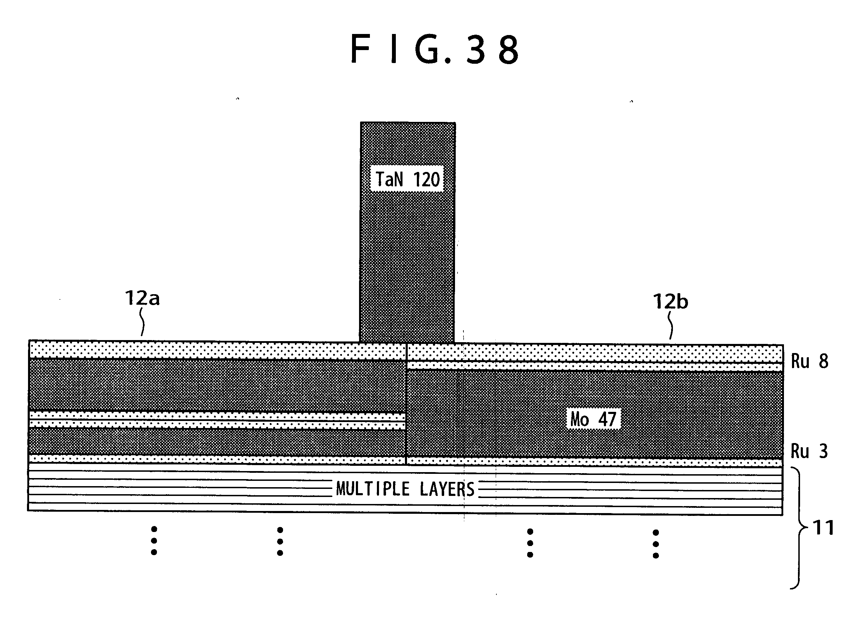

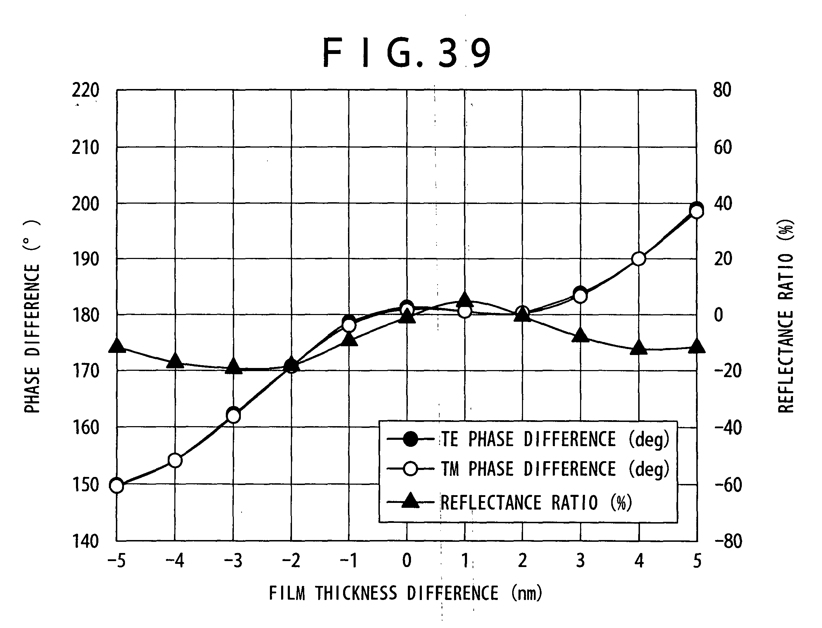

FIG. 38 is a schematic view showing a sectional structure of a different flat constitution of the Levenson phase shift mask. The illustrated structure (which will be hereinafter referred to as "a structure 5") is also obtained as the result of the calculation of the phase difference and the reflectance ratio using the film thickness of the Mo layer as the parameter, with the film thickness of the TaN layer and the film thickness of the Si layer fixed. FIG. 39 shows a result of the calculation of the phase difference and the reflectance ratio with the film thickness of the Mo layer as the parameter, with the film thickness of the TaN layer and the film thickness of the Si layer fixed. From the illustrated result, it may be confirmed that the structure 5 is also supposed to be in the form of the constitution satisfying the criteria, provided that the difference in the film thickness between the first region 12a and the second region 12b reaches 0 nm. In the structure 5, the reflectance is 0.288 with respect to the first region 12a, and 0.287 with respect to the second region 12b, in which case the reflectance ratio therebetween results in 0.36 %. Further, the phase difference between the first region 12a and the second region 12b reaches 181.4° with respect to the TE wave and 181.1° with respect to the TM wave.

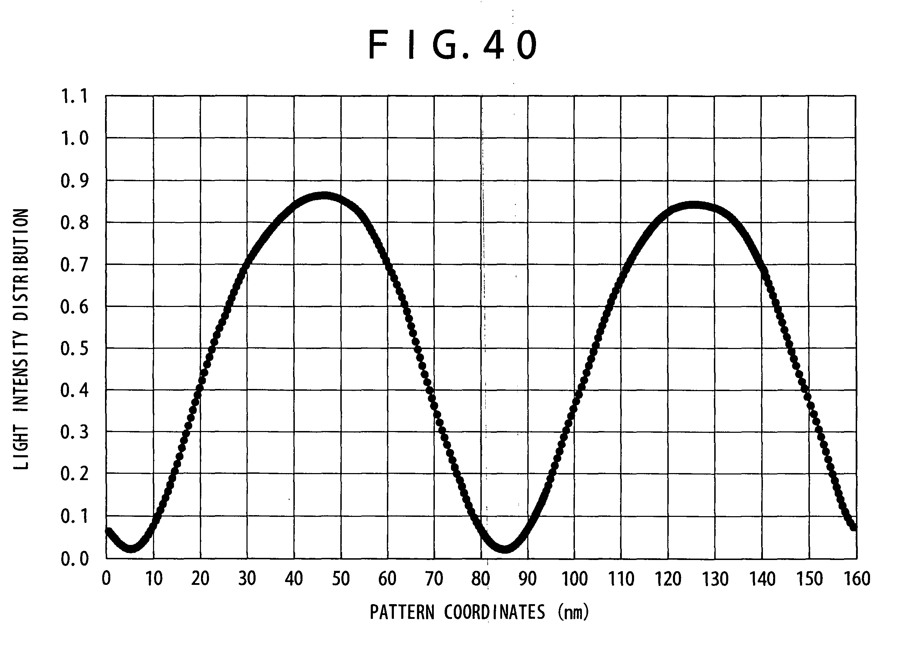

The light intensity distribution in the case of the use of the Levenson phase shift mask of the structure 5 is supposed to produce a result as shown in FIG. 40, for instance, when the optical conditions of NA = 0.25 and σ = 0.70 are applied to the case of the exposure of the wafer to the light with the 120 nm-thick TaN absorption layer formed as wide as 40 nm (10 nm in terms of the wafer unit) on the four-fold mask of the structure 5.

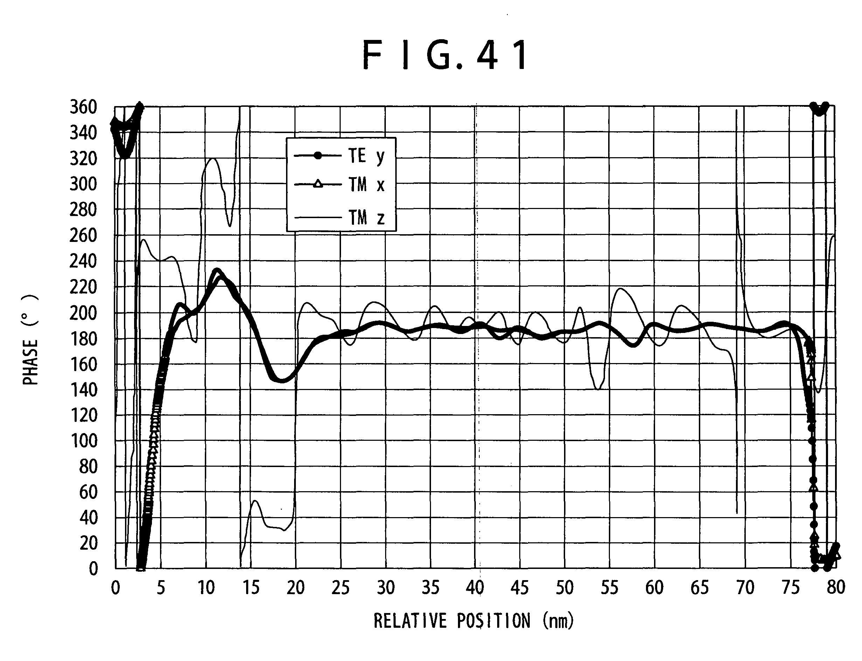

Further, 180° of the phase difference between the first region 12a and the second region 12b may be confirmed by calculating the phase difference according to the above expression (8) using the 320 nm-pitch (the 80 nm-pitch to the width of 10 nm in terms of the wafer unit) pattern with the TaN absorption layer having the width of 40 nm. FIG. 41 shows a result of the calculation of the expression (8) on the position right above the mask to the TEy wave, the TMx wave and the TMz wave. According to this illustration, both the TEy wave and the TMx wave satisfactorily hold the phase difference of 180°. On the contrary, the TMz wave shows the more outstanding deviation from 180°, in which case, however, the contribution toward the transfer is as small as about 0.45 %, resulting in no effect on the transfer.

The deposition procedure of the above structure 5 is the same as that in the case of the above structure 4.

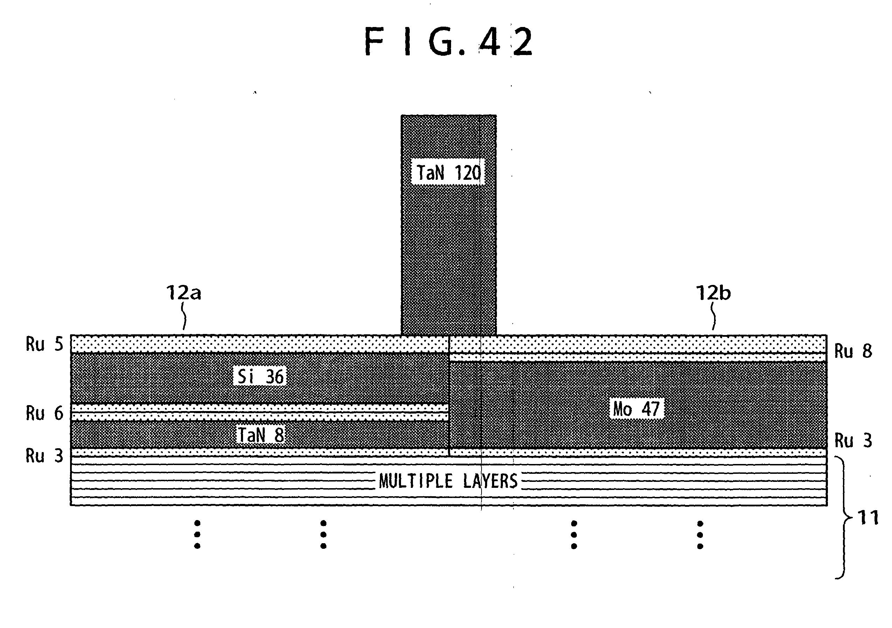

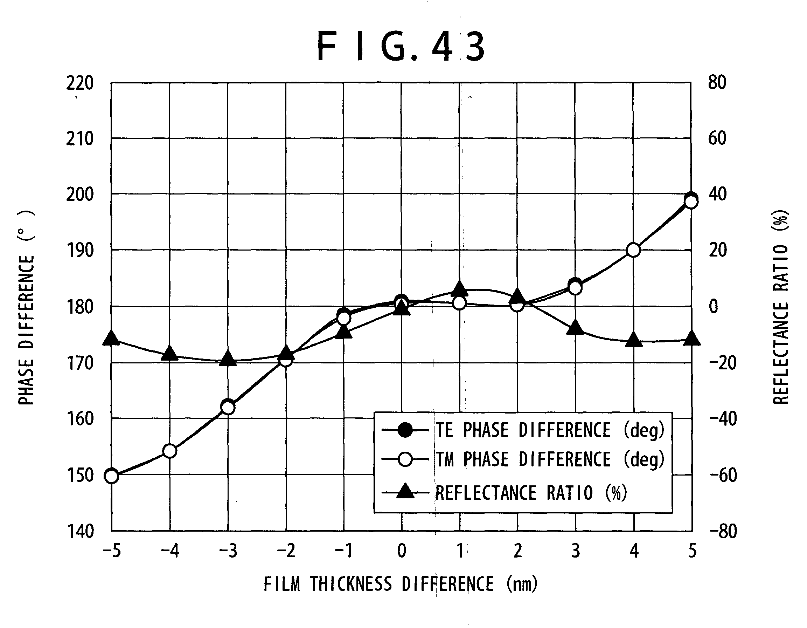

FIG. 42 is a schematic view showing a sectional structure of a further different flat constitution of the Levenson phase shift mask. The illustrated structure (which will be hereinafter referred to as "a structure 6") is also obtained as the result of the calculation of the phase difference and the reflectance ratio using the film thickness of the Mo layer as the parameter, with the film thickness of the TaN layer and the film thickness of the Mo layer fixed. FIG. 43 shows a result of the calculation of the phase difference and the reflectance ratio using the film thickness of the Mo layer as the parameter, with the film thickness of the TaN layer and the film thickness of the Si layer fixed. From the illustrated result, it may be confirmed that the structure 6 is supposed to be in the form of the constitution satisfying the criteria, provided that the difference in the film thickness between the first region 12a and the second region 12b reaches 0 nm. In the structure 6, the reflectance is 0.300 with respect to the first region 12a and 0.287 with respect to the second region 12b, in which case, the reflectance ratio therebetween results in 0.90 %. Further, the phase difference between the first region 12a and the second region 12b reaches 180.6° with respect to the TE wave and 180.3° with respect to the TM wave.

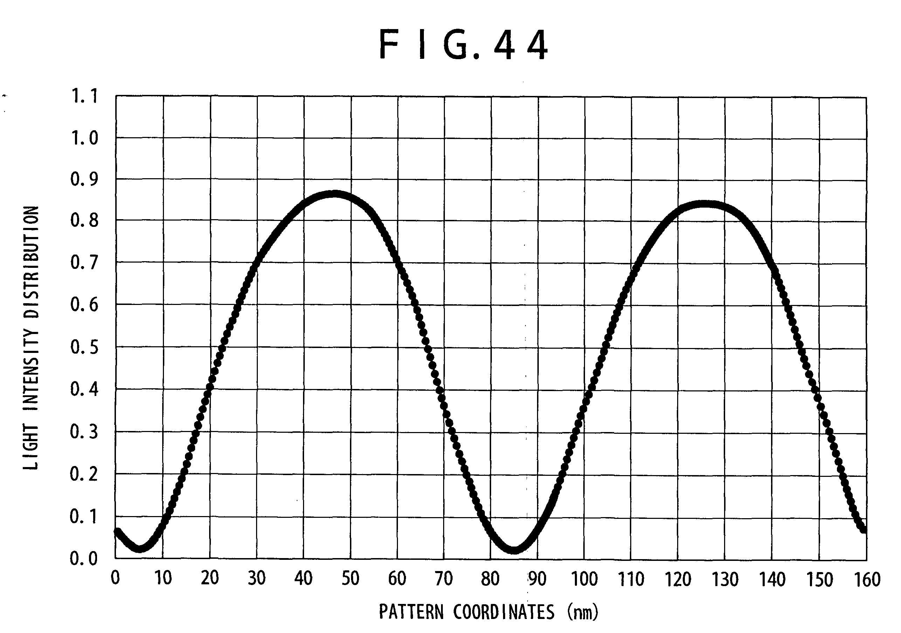

The light intensity distribution in the case of the use of the Levenson phase shift mask of the structure 6 is supposed to produce a result as shown in FIG. 44, for instance, when the optical conditions of NA = 0.25 and σ = 0.70 are applied to the case of the exposure of the wafer to the light with the 120 nm-thick TaN absorption layer formed as wide as 40 nm (10 nm in terms of the wafer unit) on the four-fold mask of the structure 6.

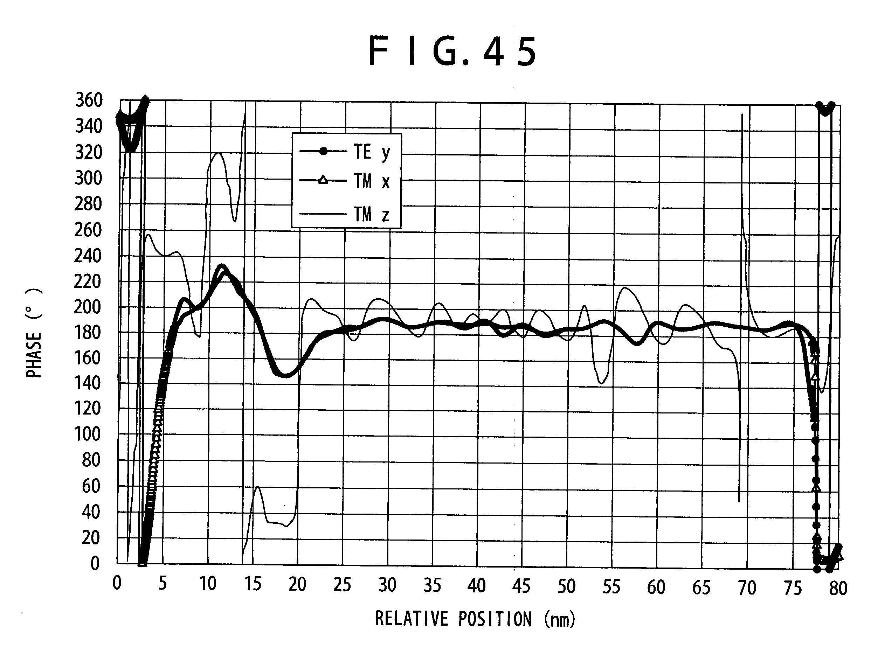

Further, 180° of the phase difference between the first region 12a and the second region 12b may be confirmed by calculating the phase difference according to the above expression (8) using the 320 nm-pitch (the 80 nm-pitch to the width of 10 nm in terms of the wafer unit) pattern with the TaN absorption layer having the width of 40 nm. FIG. 45 shows a result of the calculation of the expression (8) on the position right above the mask to the TEy wave, the TMx wave and the TMz wave. According to this illustration, both the TEy wave and the TMx wave satisfactorily hold the phase difference of 180°. On the contrary, the TMz wave shows the more outstanding deviation from 180°, in which case, however, the contribution toward the transfer is as small as about 0.45 %, resulting in no effect on the transfer.

The deposition procedure of the above structure 6 is also the same as that in the case of the above structure 4 or 5.

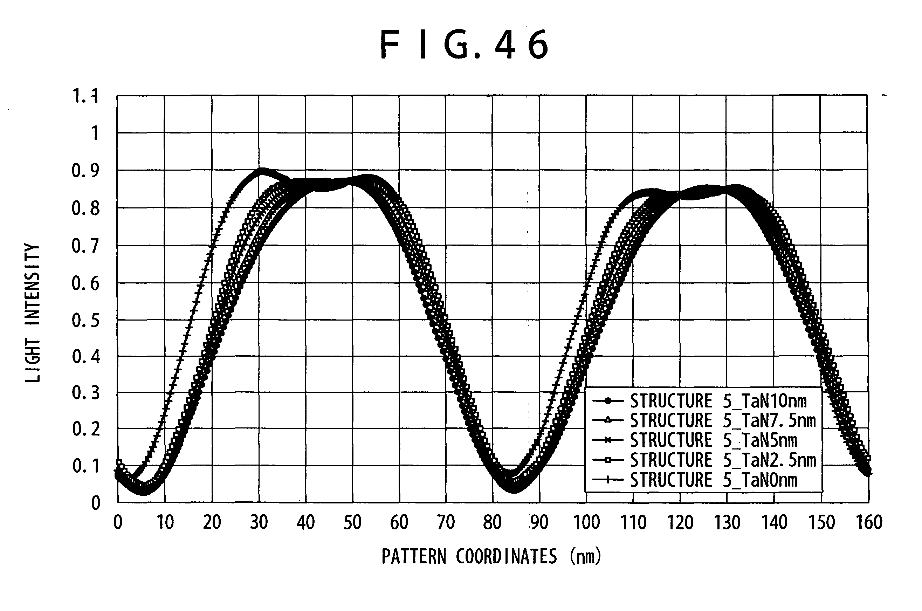

An effect on the above Levenson phase shift mask is now described as compared with that of the conventional binary mask that takes advantage of no phase shift effect. FIG. 46 illustrates the light intensity distribution obtained under the optical conditions of NA = 0.25 and σ = 0.70 in the case of the exposure of the wafer to the light with the 120 nm-thick TaN absorption layer formed as wide as of 40 nm, 30 nm, 20 nm, 10 nm and 0 nm (10 nm, 7,5 nm, 5 nm, 2.5 nm and 0 nm in terms of the wafer unit) on the four-fold mask of the structure 5 regarding the Levenson phase shift mask of the structure 5. According to this illustration, it may be appreciated that a satisfactory pattern contrast is obtained in each of the TaN absorption layer widths.

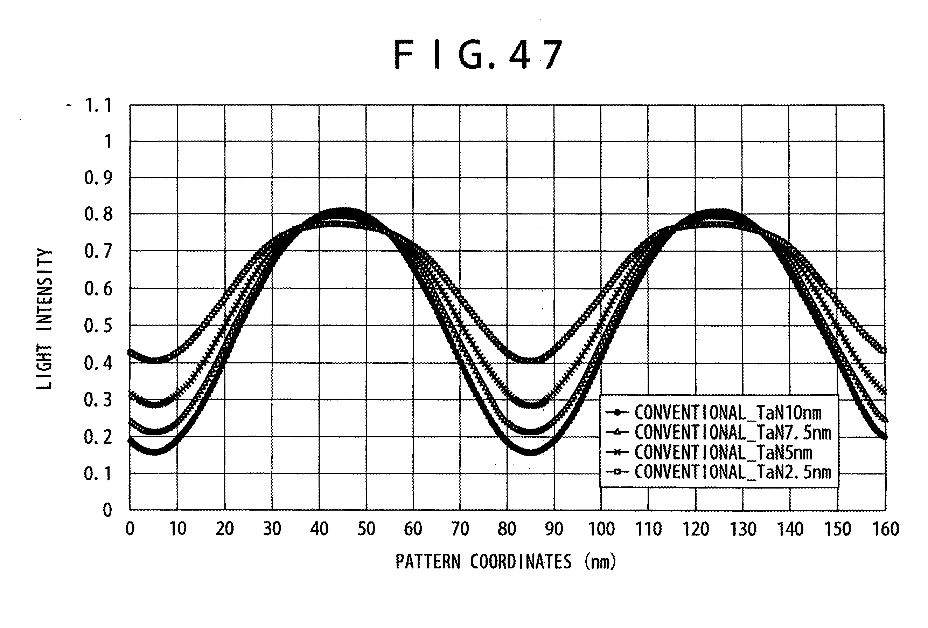

On the contrary, as for the conventional binary mask, FIG. 47 illustrates the light intensity distribution obtained under the optical conditions of NA = 0.25 and σ = 0.70 in the case of the exposure of the wafer to the light with the 120 nm-thick TaN absorption layer formed as wide as 40 nm, 30 nm, 20 nm, 10 nm and 0 nm (10 nm, 7.5 nm, 5 nm, 2.5 nm and 0 nm in terms of the wafer unit) on the above binary mask. According to this illustration, it may be appreciated that the pattern contrast remarkably decreases with decreasing TaN absorption layer width.

For the above reasons, it may be said that the use of the Levenson phase shift mask of the above structure may produce an outstanding effect of permitting the transfer of a line width of a size as small as 15 nm or below on the wafer in the case of the TaN absorption layer having the width of 10 nm (2.5 nm in terms of the wafer unit). Further, the exposure under the optical conditions of NA = 0.30, as shown in FIG. 30, for instance, is supposed to produce the outstanding effect of permitting the transfer of the line width of a size as small as 10 nm or below on the wafer in the case of the TaN absorption layer having the width of 10 nm (2.5 nm in terms of the wafer unit).

As described the above, the phase shift mask having been described in the embodiments (the first and the second embodiments) of the present invention requires that the film thickness and the complex refractive index of the formative films of the first region 12a and the second region 12b are set to ensure that the reflected light contained in the extreme ultraviolet radiation in the first and the second regions creates the prescribed phase difference. More specifically, when constituting the phase shift mask, the phase and the reflectance of the reflected light based on the arbitrary complex refractive index and the arbitrary film thickness are firstly specified with reference to the arbitrary complex refractive index and the arbitrary film thickness without depending on the formative films (the complex refractive index in the composing material of the formative films) on the reflective mask blank with multilayered films 11, and the thickness and the complex refractive index of the formative film in each of the first and the second regions are selected based on the specified phase and the specified reflectance to ensure that the first region 12a and the second region 12b create the phase difference of 180°.

Thus, according to the phase shift mask having been described in the embodiments of the present invention, even in the case of the reflective mask adapted to the extreme ultraviolet radiation, it becomes realizable to constitute the phase shift mask used for the resolution enhanced technology. That is, the use of the phase shift mask fabrication method having been described in the embodiments of the present invention enables the extreme ultraviolet phase shift mask to be constituted.

While the embodiments of the present invention have been described by taking the case where the extreme ultraviolet radiation is used as the exposure light, it is to be understood that the exposure light is not limited to the extreme ultraviolet light, and may be X-rays, radioactive rays, ultraviolet rays or a visible light. With the exposure lights described the above, it also becomes realizable to constitute the phase shift mask used for the resolution enhanced technology for the reflective mask. That is, the use of the phase shift mask fabrication method having been described in the embodiments of the present invention enables the extreme ultraviolet phase shift mask to be constituted.

Furthermore, according to the phase shift mask having been described in the embodiments of the present invention, the use of not only the extreme ultraviolet radiation but also the resolution enhanced technology remarkably increases the pattern contrast on the wafer, resulting in the attainment of the resolution that has failed to be obtained with the conventional binary mask. That is, the semiconductor apparatus, if being fabricated using the phase shift mask according to the embodiments of the present invention, may obtain more micro-miniaturized hole patterns, space patterns and line patterns than those obtained with the conventional binary mask, resulting in a quite suitable adaptation to the pattern minimization.

Furthermore, according to the phase shift mask having been described in the embodiments of the present invention, the effective utilization of the multiple interference in film makes the formative film in the first region 12a approximately equal in the film thickness with the formative film in the second region 12b, resulting in the attainment of the constitution in which the first region 12a and the second region 12b are in the flat form. Thus, even when the Levenson phase shift mask requires the TaN absorption layer formed in the boundary between the first region 12a and the second region 12b, for instance, the TaN layer may be formed at a flat portion, resulting in an easiness in performing the fabrication and also ensuring an accuracy in forming the absorption layer.

Furthermore, according to the phase shift mask having been described in the embodiments of the present invention, both or either of the formative films of the first and the second regions 12a and 12b has the multilayered structure consisting of the plurality of materials. Thus, the formative films that meet the arbitrary complex refractive index and the arbitrary film thickness may be obtained even by specifying, with reference to the arbitrary complex refractive index and the arbitrary film thickness, the phase and the reflectance of the reflected light based on the arbitrary complex refractive index and the arbitrary film thickness. That is, the use of the multilayered structure consisting of the plurality of materials enables the desired phase shift mask to be constituted.

As has been described the above, according to the exposure light phase shift mask and the phase shift mask fabrication method according to the present invention, it becomes realizable to constitute the phase shift mask for use in the resolution enhanced technology by obtaining an appropriate combination of the refractive index with the absorption coefficient, even in the case of the reflective mask adapted to the exposure light. Furthermore, according to the semiconductor apparatus fabrication method according to the present invention, the quite suitable adaptation to the pattern minimization is attainable.

In particular, it becomes realizable to constitute the phase shift mask for use in the resolution enhanced technology for the reflective mask required for the case where the extreme ultraviolet radiation is used as the exposure light. That is, the use of the phase shift mask fabrication method having been described in the embodiments of the present invention enables the extreme ultraviolet phase shift mask to be constituted.

**Claims**

1. A phase shift mask for an exposure light used to transfer a desired pattern to a light exposed material by a reflection of the exposure light, **characterized by** comprising:

   a reflective mask blank with multilayered films that reflects the exposure light; and
   a first and a second regions formed on the reflective mask blank with multilayered films,

   wherein each film thickness and each complex refractive index in a formative film of the first region and a formative film of the second region are set to form a prescribed phase difference by a reflected light contained in the exposure light in the first region and a reflected light contained in the exposure light in the second region.

2. The phase shift mask for an exposure light as cited in claim 1,
   **characterized in that**;
   said exposure light is one of an extreme ultraviolet radiation, X-rays, radioactive rays, ultraviolet rays, and a visible light.

3. The phase shift mask for an exposure light as cited in claim 1,
   **characterized in that**;
   each film thickness and each complex refractive index in a formative film of the first region and a formative film of the second region are set so that, in addition to the prescribed phase difference, a reflection rate of the reflected light contained in the exposure light in the first region and a reflection rate of the reflected light contained in the exposure light in the second region become approximately equal.

4. The phase shift mask for an exposure light as cited in claim 1,
   **characterized in that**;
   each film thickness in the formative film of the first region and the formative film of the second region are configured to be approximately equal.

5. The phase shift mask for an exposure light as cited in claim 1,
   **characterized in that**;

one or both of the formative film of the first region and the formative film of the second region comprise a multilayer structure including a plurality of materials.

**6.** The phase shift mask for an exposure light as cited in claim 3,
**characterized in that**;
each film thickness and each complex refractive index in the formative film of the first region and the formative film of the second region are set using an iso-phase contour line and an iso-reflectance contour line.

**7.** The phase shift mask for an exposure light as cited in claim 6,
**characterized in that**;
the iso-phase contour line is calculated by fixing an imaginary part of the complex refractive index.

**8.** The phase shift mask for an exposure light as cited in claim 1,
**characterized in that**;
the phase shift mask is one of a halftone phase shift mask and a Levenson phase shift mask.

**9.** A fabrication method of a phase shift mask for an exposure light having a reflective mask blank with multilayered films that reflects an exposure light, and a first and a second regions formed on the reflective mask blank with multilayered films, **characterized by**:

specifying, with reference to an arbitrary complex refractive index to the exposure light and an arbitrary film thickness of each film formed on the reflective mask blank with multilayered films, a phase and a reflectance of a reflected light contained in the exposure light based on the above complex refractive index and the above film thickness; and

selecting, based on the specified phase and the specified reflectance, each film thickness and each complex refractive index in a formative film of the first region and a formative film of the second region, so that the reflected light contained in the exposure light in the first region and the reflected light contained in the exposure light in the second region form a prescribed phase difference.

**10.** The phase shift mask for an exposure light as cited in claim 9,
**characterized in that**;
said exposure light is one of an extreme ultraviolet radiation, X-rays, radioactive rays, ultraviolet rays, and a visible light.

**11.** The fabrication method of a phase shift mask for an exposure light as cited in claim 9, **characterized in that**;
when each film thickness in the formative film of the first region and the formative film of the second region is selected, a phase difference due to a multiple interference in film and a variation of reflection rate relative to the film thickness are considered.

**12.** The fabrication method of a phase shift mask for an exposure light as cited in claim 9, **characterized in that**;
the selected complex refractive index and the film thickness are calculated based on a composite complex refractive index performed by a multilayer structure made of a plurality of materials, and a total film thickness.

**13.** The fabrication method of a phase shift mask for an exposure light as cited in claim 9, **characterized in that**;
each film thickness and each complex refractive index in the formative film of the first region and the formative film of the second region are set using an iso-phase contour line and an iso-reflectance contour line.

**14.** The fabrication method of a phase shift mask for an exposure light as cited in claim 13, **characterized in that**;
the iso-phase contour line is calculated by fixing an imaginary part of the complex refractive index.

**15.** The fabrication method of a phase shift mask for an exposure light as cited in claim 9, **characterized in that**;
the phase shift mask is one of a halftone phase shift mask and a Levenson phase shift mask.

**16.** A fabrication method of a semiconductor apparatus including a lithography process of transferring a desired pattern to a light exposed material using an exposure light phase shift mask, **characterized by**:

specifying, with reference to an arbitrary complex refractive index to the exposure light and an arbitrary film thickness of each film formed on a reflective mask blank with multilayered films, a phase and a reflectance of a reflected light contained in the exposure light based on the above complex refractive index and the above film thickness;

selecting, based on the specified phase and the specified reflectance, each film thickness and each complex refractive index in a formative film of the first region and a formative film of the second region, so that the reflected light contained in the exposure light in the first region and the reflected light contained in the exposure light in the second region form a prescribed phase difference;

forming the formative film of the first region and the formative film of the second region on the reflective mask blank with multilayered films based on the selected complex refractive index and the selected film thickness to constitute an exposure light phase shift mask having the first region and the second region on the reflective mask blank with multilayered films; and transferring the desired pattern to the light exposed material using the resultant exposure light phase shift mask.

17. The fabrication method of a semiconductor apparatus as cited in claim 16, **characterized in that**;
    said exposure light is one of an extreme ultraviolet radiation, X-rays, radioactive rays, ultraviolet rays, and a visible light.

18. The fabrication method of a semiconductor apparatus as cited in claim 18, **characterized in that**;
    each film thickness and each complex refractive index in the formative film of the first region and the formative film of the second region are set using an iso-phase contour line and an iso-reflectance contour line.

19. The fabrication method of a semiconductor apparatus as cited in claim 18, **characterized in that**;
    the iso-phase contour line is calculated by fixing an imaginary part of the complex refractive index.

20. The fabrication method of a semiconductor apparatus as cited in claim 16, **characterized in that**;
    the phase shift mask is one of a halftone phase shift mask and a Levenson phase shift mask.

INCIDENT LIGHT

10

12b

12a

14

13

11

F I G. 1 A

INCIDENT LIGHT

10′

12b

12a

14

13

11

F I G. 1 B

EP 1 536 284 A1

F I G. 2

S101 — ISO-PHASE CONTOUR LINE AND ISO-REFLECTANCE CONTOUR LINE TO EACH COMPLEX REFRACTIVE NINDEX ARE CALCULATED

S102 — WORKABLE MATERIAL AND FILM COMPOSITION ARE OBTAINED ON FIRST AND SECOND REGIONS

S103 — COMPLEX REFRACTIVE NINDEX IN MATERIAL COMPOSITION OF FIRST REGION IS CALCULATED

S104 — COMPLEX REFRACTIVE NINDEX IN MATERIAL COMPOSITION OF SECOND REGION IS CALCULATED

S105 — REQUIRED DIFFERENCE IN LEVEL BETWEEN FIRST AND SECOND REGIONS IS CALCULATED FROM ISO-PHASE CONTOUR LINE BASED ON REFRACTIVE INDEX (n1) OF FIRST REGION AND REFRACTIVE INDEX (n2) OF SECOND REGION

S106 — REFLECTANCES IN FIRST AND SECOND REGIONS ARE CALCULATED BASED ON EXTINCTION COEFFICIENT (k1) OF FIRST REGION AND EXTINCTION COEFFICIENT (k2) OF SECOND REGION

S107 — PHASE DIFFERENCE IS 180 DEGREES?

S108 — MULTIPLE REFLECTION EFFECT IN FILM IS OBTAINED TO ADJUST FILM THICKNESS OF COMPOSING MATERIAL

END

# F I G. 4

FILM THICKNESS (nm)

EP 1 536 284 A1

FIG.5

Ru FILM THICKNESS (nm)

TaN FILM THICKNESS (nm)

n=0.94〜0.945

n=0.935〜0.94

n=0.93〜0.935

n=0.925〜0.93

n=0.92〜0.925

n=0.915〜0.92

n=0.91〜0.915

n=0.905〜0.91

n=0.9〜0.905

n=0.895〜0.9

n=0.89〜0.895

# FIG. 6

EP 1 536 284 A1

# F I G. 7

| TOTAL THICKNESS (nm) | Ru THICKNESS (nm) | TaN THICKNESS (nm) |
|---|---|---|
| 40 | 20 | 20 |
| 41 | 17 | 24 |
| 42 | 15 | 27 |
| 43 | 14 | 29 |
| 44 | 15 | 29 |
| 45 | 15 | 30 |
| 46 | 14 | 32 |
| 47 | 12 | 35 |
| 48 | 9 | 39 |
| 49 | 7 | 42 |
| 50 | 7 | 43 |
| 51 | 7 | 44 |
| 52 | 7 | 45 |
| 53 | 6 | 47 |

F I G. 8

k=0.018～0.019
k=0.019～0.02
k=0.02～0.021
k=0.021～0.022
k=0.022～0.023
k=0.023～0.024  k=0.024～0.025

k=0.025～0.026
k=0.026～0.027
k=0.027～0.028
k=0.028～0.029
k=0.029～0.03
k=0.03～0.031
k=0.031～0.032

Ru FILM THICKNESS (nm)

19  17  15  13  11  9  7  5  3  1

TaN FILM THICKNESS (nm)

1  3  5  7  9  11  13  15  17  19  21  23  25  27  29  31  33  35  37  39  41  43  45  47  49

EP 1 536 284 A1

# F I G. 9

EP 1 536 284 A1

## PHASE DIFFERENCE

| Ru/TaN | 24 | 25 | 26 | 27 | 28 | 29 | 30 | 31 | 32 | 33 | 34 | 35 | 36 | 37 | 38 | 39 | 40 | 41 | 42 | 43 | 44 | 45 |
|---|---|---|---|---|---|---|---|---|---|---|---|---|---|---|---|---|---|---|---|---|---|---|
| 3 | | | | | | | | | | | | | | | | | | | | | | 166.7 |
| 4 | | | | | | | | | | | | | | | | | | | | 163.7 | 171.8 | 174.5 |
| 5 | | | | | | | | | | | | | | | | | | 158.7 | 168.2 | 176.5 | 179.9 | 176.2 |
| 6 | | | | | | | | | | | | | | | | | 161.8 | 171.2 | 179.7 | 183.6 | 180.3 | 174.7 |
| 7 | | | | | | | | | | | | | | | | | 172.3 | 181.0 | 185.1 | 181.9 | 176.1 | 176.2 |
| 8 | | | | | | | | | | | | | 154.6 | 156.1 | 163.0 | 172.4 | 181.0 | 185.1 | 181.9 | 176.1 | 176.2 | 183.0 |
| 9 | | | | | | | | | | | | | 156.9 | 163.6 | 172.9 | 181.5 | 185.7 | 182.7 | 177.0 | 177.0 | 183.7 | 193.9 |
| 10 | | | | | | | | | | | | | 166.2 | 175.3 | 183.9 | 188.4 | 185.9 | 180.4 | 180.0 | 186.3 | 196.3 | |
| 11 | | | | | | 158.3 | 165.7 | 169.4 | 167.6 | 164.2 | 167.8 | 170.7 | 179.5 | 188.2 | 193.2 | 191.5 | 186.1 | 185.1 | 190.8 | | | |
| 12 | | | | 155.4 | 163.3 | 170.9 | 175.1 | 174.0 | 170.5 | 170.6 | 175.9 | 184.5 | 193.2 | 198.7 | 197.9 | 192.8 | 191.1 | 196.0 | | | | |
| 13 | | | 159.8 | 176.6 | 175.4 | 180.0 | 179.5 | 176.0 | 175.5 | 180.4 | 188.7 | 197.6 | 203.5 | | | | | | | | | |
| 14 | | 162.4 | 170.1 | 178.0 | 182.9 | 182.6 | 179.1 | 178.3 | 182.9 | 191.2 | | | | | | | | | | | | |
| 15 | 163.0 | 170.7 | 178.6 | 183.6 | 183.3 | 179.7 | 178.9 | 183.4 | 191.7 | | | | | | | | | | | | | |
| 16 | 170.6 | 178.5 | 183.4 | 183.2 | 179.6 | 178.8 | 183.4 | 191.6 | | | | | | | | | | | | | | |
| 17 | 179.5 | 184.5 | 184.5 | 181.1 | 180.2 | 185 | 193 | | | | | | | | | | | | | | | |
| 18 | 187.9 | 188.3 | 185.2 | 184.1 | 188.1 | 195.8 | | | | | | | | | | | | | | | | |
| 19 | | 191.4 | 189.9 | 193.3 | 200.7 | | | | | | | | | | | | | | | | | |
| 20 | | 196.0 | 198.8 | | | | | | | | | | | | | | | | | | | |
| 21 | | | | | | | | | | | | | | | | | | | | | | |
| 22 | | | | | | | | | | | | | | | | | | | | | | |
| 23 | | | | | | | | | | | | | | | | | | | | | | |

## HALF TONE REFLECTANCE RANGE ▒8-10▒ ▓4-6▓ %

| Ru/TaN | 24 | 25 | 26 | 27 | 28 | 29 | 30 | 31 | 32 | 33 | 34 | 35 | 36 | 37 | 38 | 39 | 40 | 41 | 42 | 43 | 44 | 45 |
|---|---|---|---|---|---|---|---|---|---|---|---|---|---|---|---|---|---|---|---|---|---|---|
| 3 | | | | | | | | | | | | | | | | | | | | | | 6.8 |
| 4 | | | | | | | | | | | | | | | | | | | | | 7.4 | 5.4 |
| 5 | | | | | | | | | | | | | | | | | | 10.3 | 9.7 | 7.8 | 5.7 | 4.6 |
| 6 | | | | | | | | | | | | | | | | | 10.3 | 9.8 | 8.0 | 5.9 | 4.6 | 4.8 |
| 7 | | | | | | | | | | | | | | | | | 9.7 | 8.0 | 5.9 | 4.6 | 4.8 | 5.9 |
| 8 | | | | | | | | | | | | | | | | | 8.0 | 5.9 | 4.6 | 4.7 | 5.9 | 6.9 |
| 9 | | | | | | | | | | | | | 9.5 | 10.4 | 10.0 | 8.2 | 6.1 | 4.7 | 4.9 | 6.0 | 7.1 | 7.1 |
| 10 | | | | | | | | | | | | | 10.9 | 10.5 | 8.7 | 6.5 | 5.1 | 5.1 | 6.3 | 7.4 | 7.4 | |
| 11 | | | | | | | | 10.5 | 8.8 | 8.9 | 10.3 | 11.5 | 11.2 | 9.4 | 7.1 | 5.5 | 5.4 | 6.5 | 7.7 | | | |
| 12 | | | | 17.6 | 16.8 | 14.2 | 11.2 | 9.3 | 9.2 | 10.6 | 11.8 | 11.7 | 10.0 | 7.7 | 5.9 | 5.6 | 6.6 | 7.9 | | | | |
| 13 | | | 17.7 | 17.1 | 14.7 | 11.7 | 9.5 | 9.3 | 10.5 | 11.9 | 11.9 | 10.4 | 8.0 | | | | | | | | | |
| 14 | | 17.5 | 17.0 | 14.7 | 11.7 | 9.5 | 9.1 | 10.3 | 11.7 | 11.8 | 17.2 | | | | | | | | | | | |
| 15 | | 16.7 | 14.5 | 9.4 | 9.3 | 8.9 | 10.1 | 11.5 | 11.6 | | | | | | | | | | | | | |
| 16 | 16.9 | 14.6 | 11.6 | 9.4 | 9.0 | 10.2 | 11.6 | 11.7 | | | | | | | | | | | | | | |
| 17 | 15.3 | 12.2 | 9.9 | 9.5 | 10.7 | 12 | 12 | | | | | | | | | | | | | | | |
| 18 | 13.3 | 10.9 | 10.2 | 11.4 | 12.8 | 13.1 | | | | | | | | | | | | | | | | |
| 19 | | 10.9 | 11.9 | 13.4 | 13.9 | | | | | | | | | | | | | | | | | |
| 20 | | 12.1 | 13.6 | | | | | | | | | | | | | | | | | | | |
| 21 | | | | | | | | | | | | | | | | | | | | | | |
| 22 | | | | | | | | | | | | | | | | | | | | | | |
| 23 | | | | | | | | | | | | | | | | | | | | | | |

# F I G. 1 0

PHASE DIFFERENCE

| Ru/Cr | 25 | 26 | 27 | 28 | 29 | 30 | 31 | 32 | 33 | 34 | 35 | 36 | 37 |
|---|---|---|---|---|---|---|---|---|---|---|---|---|---|
| 0 | | | | | | 106.3 | 159.4 | 168.7 | 178.9 | 186.2 | 186.8 | 180.9 | 177.5 |
| 1 | | | | | | | | | | 133.953 | 128.115 | 124.696 | 129.087 |
| 2 | | | | | | | | | | | 126.647 | 130.742 | 140.4 |
| 3 | | | | | | | | | | | 134.212 | 143.416 | 154.824 |
| 4 | | | | | | | | | | 138.817 | 147.444 | 158.579 | 168.608 |
| 5 | | | | | | | | | 158.6 | 151.3 | 162.2 | 172.4 | 177.5 |
| 6 | | | | | | | | 146.2 | 154.0 | 164.7 | 175.0 | 180.5 | 177.2 |
| 7 | | | | | | | 147.361 | 155.0 | 165.7 | 176.0 | 181.7 | 178.6 | 170.8 |
| 8 | | | | | | 147.4 | 155.0 | 165.8 | 176.1 | 181.7 | 178.7 | 170.9 | 169.9 |
| 9 | | | 286.0 | 146.5 | 148.0 | 155.5 | 166.1 | 176.4 | 182.1 | 179.2 | 171.6 | 170.5 | 177.8 |
| 10 | | 153.3 | 149.2 | 150.3 | 157.5 | 167.9 | 178.1 | 184.0 | 181.71 | 174.41 | 173.034 | 179.92 | 191.385 |
| 11 | 157.9 | 153.9 | 154.6 | 161.2 | 171.2 | 181.35 | 187.667 | 186.276 | 179.45 | 177.51 | 183.68 | 194.657 | 206.692 |
| 12 | 159.5 | 159.6 | 165.6 | 175.3 | 185.39 | 192.153 | 191.711 | 185.37 | 182.8 | 188.174 | 198.644 | 210.516 | 219.835 |
| 13 | 164.0 | 169.5 | 178.9 | 188.971 | 196.115 | 196.419 | 190.458 | 187.361 | 192.079 | 202.151 | | | |
| 14 | 172 | 181 | 191.146 | 198.528 | 199.238 | 193.435 | 194.351 | 204.231 | 215.995 | | | | |

| Ru/Cr | 38 | 39 | 40 | 41 | 42 | 43 | 44 | 45 | 46 | 47 | 48 | 49 | 50 |
|---|---|---|---|---|---|---|---|---|---|---|---|---|---|
| 0 | 182.0 | 191.9 | 203.7 | 213.5 | 216.3 | 208.7 | 200.9 | 203.7 | 214.2 | 227.8 | 240.4 | 246.7 | 238.9 |
| 1 | 138.996 | 150.8 | 160.6 | 163.4 | 155.9 | 148.1 | 150.8 | 161.3 | 174.8 | 367.4 | 373.7 | 366.1 | 171.8 |
| 2 | 152.0 | 161.9 | 165.0 | 158.0 | 150.2 | 152.6 | 162.7 | 176.0 | 188.6 | 195.1 | 188.2 | 174.2 | 173.5 |
| 3 | 164.7 | 168.5 | 162.4 | 154.6 | 256.2 | 165.7 | 178.7 | 191.2 | 198.2 | 192.6 | 179.1 | 177.3 | 187.0 |
| 4 | 173.1 | 168.2 | 160.3 | 161.0 | 169.8 | 182.3 | 194.8 | 202.4 | 198.4 | 185.4 | 182.4 | 191.1 | |
| 5 | 173.6 | 165.8 | 165.6 | 173.7 | 185.8 | 198.3 | 206.4 | 203.8 | 191.4 | 187.3 | 195.0 | 208.5 | |
| 6 | 169.5 | 168.7 | 176.3 | 188.3 | 200.701 | 209.2 | 207.5 | 195.5 | 195.5 | | | | |
| 7 | 169.8 | 177.3 | 189.2 | 201.7 | 210.3 | 208.9 | 197.0 | 191.8 | | | | | |
| 8 | 177.3 | 189.252 | 201.7 | 210.4 | 209.0 | | | | | | | | |
| 9 | 189.621 | 202.003 | | | | | | | | | | | |
| 10 | 203.604 | | | | | | | | | | | | |
| 11 | 215.695 | | | | | | | | | | | | |
| 12 | 221.344 | | | | | | | | | | | | |
| 13 | | | | | | | | | | | | | |
| 14 | | | | | | | | | | | | | |

EP 1 536 284 A1

# F I G. 1 1

HALF TONE REFLECTANCE 4-6%

| Ru/Cr | 25 | 26 | 27 | 28 | 29 | 30 | 31 | 32 | 33 | 34 | 35 | 36 | 37 |
|---|---|---|---|---|---|---|---|---|---|---|---|---|---|
| 0 | | | | | | 12.9 | 12.9 | 13.0 | 11.1 | 8.3 | 6.0 | 5.3 | 6.2 |
| 1 | | | | | | | | | | 6.0 | 5.3 | 6.3 | 7.8 |
| 2 | | | | | | | | | | | 6.52266 | 8.06266 | 8.7 |
| 3 | | | | | | | | | | | 8.5 | 9.2 | 8.4 |
| 4 | | | | | | | | | | 8.9 | 9.8 | 9.1 | 7.1 |
| 5 | | | | | | | | | 2.8 | 10.3 | 9.7 | 7.6 | 5.3 |
| 6 | | | | | | | | 9.4 | 10.5 | 10.0 | 8.0 | 5.5 | 4.0 |
| 7 | | | | | | | 9.32535 | 10.5 | 10.0 | 8.0 | 5.6 | 4.0 | 4.0 |
| 8 | | | | | | 9.3 | 10.4 | 10.0 | 8.0 | 5.6 | 4.0 | 4.0 | 5.2 |
| 9 | | | 6.0 | 7.9 | 9.5 | 10.7 | 10.2 | 8.2 | 5.8 | 4.1 | 4.1 | 5.4 | 6.6 |
| 10 | | 8.1 | 8.4 | 10.1 | 11.3 | 10.9 | 8.8 | 6.3 | 4.5 | 4.4 | 5.6 | 6.9 | 7.2 |
| 11 | 9.0 | 9.1 | 10.7 | 12.0 | 11.7 | 9.7 | 7.0 | 5.0 | 4.8 | 6.0 | 7.4 | 7.7 | 6.5 |
| 12 | 9.7 | 11.3 | 12.7 | 12.5 | 10.5 | 7.7 | 5.6 | 5.1 | 6.2 | 7.7 | 8.2 | 7.1 | 5.1 |
| 13 | 11.6 | 13.1 | 13.0 | 11.1 | 8.3 | 6.0 | 5.3 | 6.4 | 7.9 | 8.4 | | | |
| 14 | 13.1 | 13.1 | 11.3 | 8.4 | 6.1 | 5.3 | 7.8 | 8.5 | 7.6 | | | | |

| Ru/Cr | 38 | 39 | 40 | 41 | 42 | 43 | 44 | 45 | 46 | 47 | 48 | 49 | 50 |
|---|---|---|---|---|---|---|---|---|---|---|---|---|---|
| 0 | 7.7 | 8.4 | 7.5 | 5.5 | 3.6 | 2.7 | 3.3 | 4.5 | 5.4 | 5.1 | 3.8 | 2.3 | 1.4 |
| 1 | 8.4 | 7.5 | 5.6 | 3.6 | 2.8 | 3.3 | 4.5 | 5.4 | 5.1 | 3.9 | 2.3 | 1.4 | 1.6 |
| 2 | 7.9 | 5.9 | 3.9 | 2.9 | 3.4 | 4.7 | 5.6 | 5.3 | 4.1 | 2.5 | 1.5 | 1.7 | 2.6 |
| 3 | 6.4 | 4.3 | 3.2 | 3.6 | 4.9 | 5.9 | 5.7 | 4.4 | 2.8 | 1.7 | 1.8 | 2.7 | 3.7 |
| 4 | 4.8 | 3.5 | 3.8 | 5.1 | 6.2 | 6.1 | 4.8 | 3.1 | 1.9 | 1.9 | 2.8 | 3.8 | |
| 5 | 3.8 | 4.0 | 5.2 | 6.4 | 6.4 | 5.2 | 3.4 | 2.1 | 2.0 | 2.8 | 3.9 | 4.3 | |
| 6 | 4.0 | 5.3 | 6.5 | 6.6 | 5.4 | 3.6 | 2.2 | 2.0 | | | | | |
| 7 | 5.2 | 6.5 | 6.6 | 5.5 | 3.7 | 2.3 | 2.0 | 2.8 | | | | | |
| 8 | 6.5 | 6.6 | 5.5 | 3.7 | 2.3 | | | | | | | | |
| 9 | 6.8 | 5.6 | | | | | | | | | | | |
| 10 | 6.0 | | | | | | | | | | | | |
| 11 | 4.5986 | | | | | | | | | | | | |
| 12 | 3.3 | | | | | | | | | | | | |
| 13 | | | | | | | | | | | | | |
| 14 | | | | | | | | | | | | | |

# F I G. 1 2

# F I G. 1 3

F I G. 1 4

S201 → ISO-PHASE CONTOUR LINE AND ISO-REFLECTANCE CONTOUR LINE TO EACH COMPLEX REFRACTIVE NINDEX ARE CALCULATED

↓

S202 → WORKABLE MATERIAL AND FILM COMPOSITION ARE OBTAINED ON FIRST AND SECOND REGIONS

↓

S203 → COMPLEX REFRACTIVE NINDEX IN MATERIAL COMPOSITION OF FIRST REGION IS CALCULATED

↓

S204 → COMPLEX REFRACTIVE NINDEX IN MATERIAL COMPOSITION OF SECOND REGION IS CALCULATED

↓

S205 → REQUIRED DIFFERENCE IN LEVEL BETWEEN FIRST AND SECOND REGIONS IS CALCULATED FROM ISO-PHASE CONTOUR LINE BASED ON REFRACTIVE INDEX (n1) OF FIRST REGION AND REFRACTIVE INDEX (n2) OF SECOND REGION

↓

S206 → REFLECTANCES IN FIRST AND SECOND REGIONS ARE CALCULATED BASED ON EXTINCTION COEFFICIENT (k1) OF FIRST REGION AND EXTINCTION COEFFICIENT (k2) OF SECOND REGION

↓

S207 → REFLECTANCE IS EQUAL AND PHASE DIFFERENCE IS 180 DEGREES?

S208 → MULTIPLE REFLECTION EFFECT IN FILM IS OBTAINED TO ADJUST FILM THICKNESS OF COMPOSING MATERIAL

↓

END

# FIG.15

EP 1 536 284 A1

EP 1 536 284 A1

# F I G . 1 6

TaN 120

12b

12a

Ru 2

Ru 4

Mo 49

TaN 7

Ru 2

Ru 4

MULTIPLE LAYERS

11

# F I G. 1 7

EP 1 536 284 A1

# F I G. 1 8

# F I G. 1 9

EP 1 536 284 A1

# F I G. 2 0

PROCESS 1 :
Ru COATING

PROCESS 2 :
TaN COATING

PROCESS 3 :
RESIST COATING

PROCESS 4 :
RESIST PATTERNING

PROCESS 5 :
TaN ETCHING

PROCESS 6 :
RESIST SEPARATION

PROCESS 7 :
Ru COATING

PROCESS 8 :
Mo COATING

# F I G. 2 1

PROCESS 9 :
RESIST COATING

PROCESS 10 :
RESIST PATTERNING

PROCESS 11 :
Mo ETCHING

PROCESS 12 :
RESIST SEPARATION

PROCESS 13 :
Ru COATING

# F I G. 2 2

PROCESS 14 :
TaN COATING

PROCESS 15 :
RESIST COATING

PROCESS 16 :
RESIST PATTERNING

# F I G. 2 3

PROCESS 17 :
TaN ETCHING

PROCESS 18 :
RESIST SEPARATION

EP 1 536 284 A1

TaN 120

12b

12a

Ru 4

Mo 49

Ru 7

TaN 5

Ru 3

Ru 3

MULTIPLE LAYERS

11

# F I G. 2 5

- ●—— TE PHASE DIFFERENCE (deg)
- ○—— TM PHASE DIFFERENCE (deg)
- ▲—— REFLECTANCE RATIO (%)

EP 1 536 284 A1

F I G. 2 6

F I G. 2 7

# F I G. 2 8

# FIG.29

F I G. 3 0

# FIG. 31

EP 1 536 284 A1

# FIG. 32

EP 1 536 284 A1

# F I G. 3 3

# F I G. 3 4

# F I G. 3 5

EP 1 536 284 A1

# F I G. 3 6

PROCESS 13 :
Ru COATING

PROCESS 13-1 :
Si COATING

PROCESS 13-2 :
RESIST COATING

PROCESS 13-3 :
RESIST PATTERNING

# F I G. 3 7

PROCESS 13-4 :
Si ETCHING

PROCESS 13-5 :
RESIST SEPARATION

PROCESS 13-6 :
Ru COATING

PROCESS 14 :
TaN COATING

# F I G. 3 8

EP 1 536 284 A1

TaN 120

12a

12b

Ru 8

Mo 47

Ru 3

MULTIPLE LAYERS

11

F I G . 3 9

# F I G. 4 0

F I G. 41

# F I G. 4 2

EP 1 536 284 A1

# F I G. 4 3

F I G. 4 4

# F I G. 4 5

EP 1 536 284 A1

# FIG. 46

EP 1 536 284 A1

F I G. 4 7

EP 1 536 284 A1

F I G. 4 8

## INTERNATIONAL SEARCH REPORT

| | International application No. |
|---|---|
| | PCT/JP03/08377 |

**A. CLASSIFICATION OF SUBJECT MATTER**
Int.Cl$^7$ G03F1/16, H01L21/027

According to International Patent Classification (IPC) or to both national classification and IPC

**B. FIELDS SEARCHED**

Minimum documentation searched (classification system followed by classification symbols)
Int.Cl$^7$ G03F1/08, G03F1/16, H01L21/027

Documentation searched other than minimum documentation to the extent that such documents are included in the fields searched
| Jitsuyo Shinan Koho | 1922–1996 | Jitsuyo Shinan Toroku Koho | 1996–2003 |
| Kokai Jitsuyo Shinan Koho | 1971–2003 | Toroku Jitsuyo Shinan Koho | 1994–2003 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | US 5399448 A (Nikon Corp.), 21 March, 1995 (21.03.95), | 1-3,5,8-10, 12,15-17,20 |
| Y | Column 4, line 65 to column 7, line 11; Figs. 3, 4 | 4,11 |
| A | & JP 5-134385 A Par. Nos. [0024] to [0033]; Figs. 4, 5 | 6,7,13,14, 18,19 |
| X | US 5641593 A (Canon Kabushiki Kaisha), 24 June, 1997 (24.06.97), | 1,2,8-10,12, 15-17,20 |
| Y | Column 6, line 57 to column 7, line 40; Figs. 1, 3 | 3-5,11 |
| A | & JP 7-114173 A Par. Nos. [0017] to [0021]; Figs. 1, 3 | 6,7,13,14, 18,19 |

☒ Further documents are listed in the continuation of Box C. ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 06 October, 2003 (06.10.03) | 21 October, 2003 (21.10.03) |

| Name and mailing address of the ISA/ | Authorized officer |
|---|---|
| Japanese Patent Office | |
| Facsimile No. | Telephone No. |

Form PCT/ISA/210 (second sheet) (July 1998)

**INTERNATIONAL SEARCH REPORT**

| International application No. |
|---|
| PCT/JP03/08377 |

C (Continuation).   DOCUMENTS CONSIDERED TO BE RELEVANT

| Category* | Citation of document, with indication, where appropriate, of the relevant passages | Relevant to claim No. |
|---|---|---|
| X | EP 708367 A1  (AT&T Corp.),<br>24 April, 1996 (24.04.96), | 1,2,5,8-10,<br>12,15-17,20 |
| Y | Column 5, line 2 to column 7, line 17; Figs. 1, 2 | 3,4,11 |
| A | & JP 8-213312 A<br>Par. Nos. [0020] to [0031]; Figs. 1, 2<br>& US 521031 A          & DE 69501452 E | 6,7,13,14,<br>18,19 |
| Y | US 5514499 A  (Kabushiki Kaisha Toshiba),<br>07 May, 1996 (07.05.96),<br>Full text; all drawings<br>& JP 7-319147 A          & KR 168134 B1 | 1-5,8-10,12,<br>15-17,20 |
| P,X | EP 1260861 A1  (ASML Netherlands B.V.),<br>27 November, 2002 (27.11.02), | 1-5,8-10,12,<br>15-17,20 |
| P,Y | Full text; all drawings | 11 |
| P,A | & JP 2003-59822 A        & US 2003/31938 A1<br>& KR 2003006968 A | 6,7,13,14,<br>18,19 |
| Y | JP 7-110571 A  (Toppan Printing Co., Ltd.),<br>25 April, 1995 (25.04.95),<br>Abstract<br>(Family: none) | 3 |
| Y | US 5294506 A  (Mitsubishi Denki Kabushiki Kaisha),<br>15 March, 1994 (15.03.94),<br>Abstract; column 2, lines 15 to 54<br>& JP 4-313754 A<br>Abstract; Par. No. [0009] | 3 |
| Y | JP 4-214559 A  (Dainippon Printing Co., Ltd.),<br>05 August, 1992 (05.08.92),<br>Abstract<br>(Family: none) | 4 |
| Y | JP 9-311431 A  (Toppan Printing Co., Ltd.),<br>02 December, 1997 (02.12.97),<br>Par. No. [0018]<br>(Family: none) | 11 |
| Y | US 5700605 A  (Kabushiki Kaisha Toshiba),<br>23 December, 1997 (23.12.97),<br>Column 7, lines 51 to 56<br>& JP 8-314116 A<br>Par. No. [0029]<br>& KR 197771 B1          & TW 399247 A | 11 |
| Y | JP 8-202016 A  (Sony Corp.),<br>09 August, 1996 (09.08.96),<br>Abstract<br>(Family: none) | 11 |
| A | US 2002/045108 A1  (Byoung-taek Lee et al.),<br>18 April, 2002 (18.04.02),<br>Abstract<br>& JP 2002-122981 A        & KR 2002029590 A | 1-20 |

Form PCT/ISA/210 (continuation of second sheet) (July 1998)

**INTERNATIONAL SEARCH REPORT**

| International application No. |
| --- |
| PCT/JP03/08377 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | US 6178221 B1 (Advanced Micro Devices, Inc.), 23 January, 2001 (23.01.01), Abstract (Family: none) | 1-20 |

Form PCT/ISA/210 (continuation of second sheet) (July 1998)

## INTERNATIONAL SEARCH REPORT

International application No.

PCT/JP03/08377

**Box I    Observations where certain claims were found unsearchable (Continuation of item 2 of first sheet)**

This international search report has not been established in respect of certain claims under Article 17(2)(a) for the following reasons:

1. ☐ Claims Nos.:

because they relate to subject matter not required to be searched by this Authority, namely:

2. ☐ Claims Nos.:

because they relate to parts of the international application that do not comply with the prescribed requirements to such an extent that no meaningful international search can be carried out, specifically:

3. ☐ Claims Nos.:

because they are dependent claims and are not drafted in accordance with the second and third sentences of Rule 6.4(a).

**Box II    Observations where unity of invention is lacking (Continuation of item 3 of first sheet)**

This International Searching Authority found multiple inventions in this international application, as follows:

    Claims 1-20 has as a common feature a phase shift mask comprising a reflection
 multi-layer film substrate for reflecting a exposure light, and a first region
 and a second region formed on the substrate, wherein respective film thicknesses
 and complex refractive indexes of a formed film in the first region
 and a formed film in the second region are set so as to produce a specified
 phase difference between the reflection light of an exposure light in the
 first region and the reflection light of an exposure light in the second region.
    However, the common feature is well known prior art and is not a special
 technical feature within the meaning of PCT Rule 13.2, second
 (continued to extra sheet)

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**      ☐ The additional search fees were accompanied by the applicant's protest.

                          ☒ No protest accompanied the payment of additional search fees.

Form PCT/ISA/210 (continuation of first sheet (1)) (July 1998)

| **INTERNATIONAL SEARCH REPORT** | International application No. |
|---|---|
| | PCT/JP03/08377 |

Continuation of Box No.II of continuation of first sheet(1)

sentence. In addition, there exists no other common feature to be considered to be a special technical feature within the meaning of PCT Rule 13.2, second sentence, therefore no technical relationship within the meaning of PCT Rule 13 can be found among those different inventions

Form PCT/ISA/210 (extra sheet) (July 1998)